# EUROPEAN PATENT SPECIFICATION

(11) **EP 0 598 592 B1**
(45) Date of publication and mention of the grant of the patent: **01.09.1999**
(21) Application number: 93309141.5
(22) Date of filing: 16.11.1993
(51) Int. Cl.: G11B 7/12, G11B 7/135, G11B 7/09, G11B 7/125, G11B 33/14

(54) **Optical head**
Optischer Abtastkopf
Tête optique

(30) Priority: 17.11.1992 JP 30732292; 25.11.1992 JP 31534292; 08.02.1993 JP 2035493; 13.04.1993 JP 8653093; 20.04.1993 JP 9289393
(43) Date of publication of application: 25.05.1994
(73) Proprietor: SEIKO EPSON CORPORATION, Shinjuku-ku, Tokyo 163-0811 (JP)
(72) Inventor: Seki, Hideya, c/o Seiko Epson Corporation, Suwa-shi, Nagano-ken 392 (JP); Yonekubo, Masatoshi, c/o Seiko Epson Corporation, Suwa-shi, Nagano-ken 392 (JP); Arimura, Toshio, c/o Seiko Epson Corporation, Suwa-shi, Nagano-ken 392 (JP); Takeda, Takashi, c/o Seiko Epson Corporation, Suwa-shi, Nagano-ken 392 (JP)
(74) Representative: Sturt, Clifford Mark

(56) References cited:
- EP-A- 0 199 565
- EP-A- 0 478 222
- WO-A-87/06386
- US-A- 5 157 649
- PATENT ABSTRACTS OF JAPAN vol. 17 no. 132 (P-1504) ,18 March 1993 & JP-A-04 311828 (HITACHI LTD) 4 November 1992,
- PATENT ABSTRACTS OF JAPAN vol. 12 no. 363 (P-764) ,29 September 1988 & JP-A-63 113948 (MITSUBISHI ELECTRIC CORP.) 18 May 1988,
- PATENT ABSTRACTS OF JAPAN vol. 15 no. 23 (P-1155) ,18 January 1991 & JP-A-02 265036 (OLYMPUS OPTICAL CO LTD) 29 October 1990,
- PATENT ABSTRACTS OF JAPAN vol. 14 no. 580 (E-1017) ,25 December 1990 & JP-A-02 253687 (MITSUBISHI ELECTRIC CORP.) 12 October 1990,
- PATENT ABSTRACTS OF JAPAN vol. 10 no. 147 (P-460) ,29 May 1986 & JP-A-61 000941 (MATSUSHITA DENKI SANGYO KK) 6 January 1986,
- PATENT ABSTRACTS OF JAPAN vol. 11 no. 144 (P-574) ,12 May 1987 & JP-A-61 280044 (MITSUBISHI ELECTRIC CORP.) 10 December 1986,
- IEEE GASAS IC SYMP, 6 November 1988 - 9 November 1988 NASHVILLE TENNESSEE, pages 151-154, KOBAYASHI ET AL. 'A high frequency GaAs Multivibrator IC'
- PATENT ABSTRACTS OF JAPAN vol. 16 no. 255 (E-1214) ,10 June 1992 & JP-A-04 056291 (MATSUSHITA ELECTRON CORP.) 24 February 1992,
- PATENT ABSTRACTS OF JAPAN vol. 15 no. 471 (P-1282) ,28 November 1991 & JP-A-03 203044 (MATSUSHITA ELECTRIC IND. CO. LTD.) 4 September 1991,
- PATENT ABSTRACTS OF JAPAN vol. 10 no. 149 (P-461) ,30 May 1986 & JP-A-61 003326 (MITSUBISHI DENKI KK) 9 January 1986,
- PATENT ABSTRACTS OF JAPAN vol. 14 no. 438 (P-1108) ,19 September 1990 & JP-A-02 172029 (SEIKO EPSON CORP.) 3 July 1990,
- PATENT ABSTRACTS OF JAPAN vol. 6 no. 32 (E-96) ,26 February 1982 & JP-A-56 150889 (FUJITSU LTD) 21 November 1981,
- PATENT ABSTRACTS OF JAPAN vol. 16 no. 527 (P [1447] ,29 October 1992 & JP-A-04 195936 (NEC CORP.) 15 July 1992,
- PATENT ABSTRACTS OF JAPAN vol. 11 no. 181 (P-585) ,11 June 1987 & JP-A-62 009545 (OLYMPUS OPTICAL CO. LTD.) 17 January 1987,
- PATENT ABSTRACTS OF JAPAN vol. 12 no. 303 (P-746) ,18 August 1988 & JP-A-63 074149 (FUJITSU LTD) 4 April 1988,

## Description

The present invention relates to an optical head and applicable laser emission unit for reading from and writing into an optical memory medium such as an optical disk or the like, and more particularly to an optical head having a smaller size which is preferably applied to an optical memory device of the type having a reduced size and light weight.

In recent years, many items of electrical and/or electronic equipment and devices have been reduced in size including optical memory devices with an optical memory medium such as an optical disk etc. In order to realise a smaller device, it is important to reduce the size of an optical head, because the installation and moving space for the optical head can be reduced, if a smaller optical head is used. Further, if the weight of the small optical head is reduced to become lighter, any transporting mechanism for the optical head can be minimised, and a very small memory device can be provided. In addition, if a smaller and lighter optical head is used, positioning for reading and writing of the optical head in the memory device, would be finely controlled, and so any writing and reading error would be minimised.

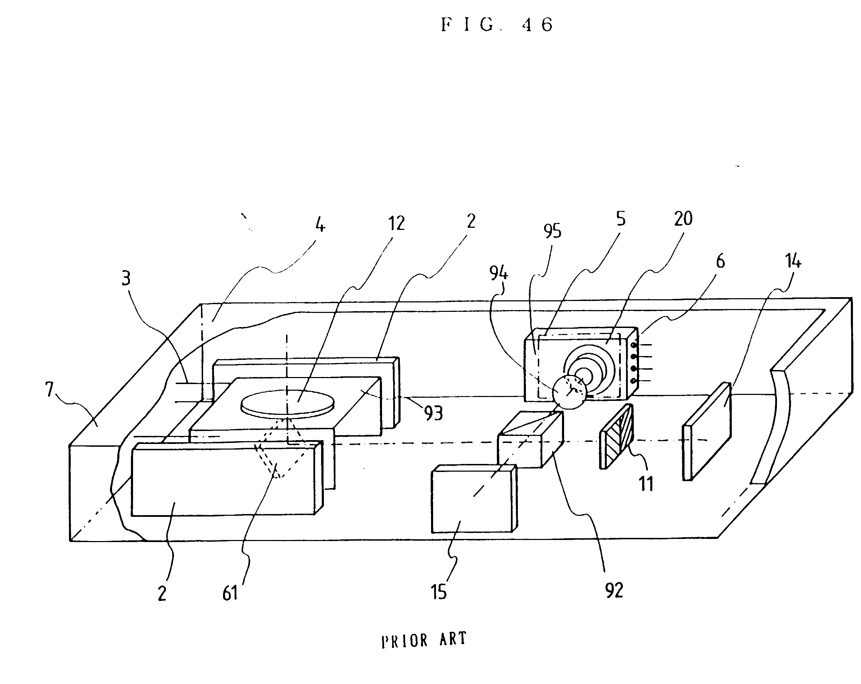

Figure 46 shows a conventional optical head, which comprises a housing 7 having a laser emission unit 20 with a laser diode, a prism 92 for changing perpendicularly the direction of a laser beam emitted from the laser emission unit 20 and passed through a collimator lens 94, a laser output power detection portion 15 for detecting a part of the laser beam passing through the prism 92 to determine an output power of the laser emission unit 20, a diffraction portion 11 for diffracting a laser beam (returned beam) reflected from an optical disk provided outside of the housing, a data detection portion 14 for a detecting a reflected beam diffracted by the diffraction portion 11, and a mirror 61 for changing again the direction of the laser beam angled by the prism 92 to an objective lens 12 through which the laser beam is sent out. The returned beam from the optical disk is returned into the optical head again via the objective lens 12. The returned beam is reflected by the mirror 61 and passes through the prism 92 and diffraction portion 11, to thereby converge on the data detection portion 14 for detecting a position error signal and recorded signal. The objective lens 12 is supported by a position control mechanism 93 in order to realise fine focusing control of the laser beam. The control mechanism 93 is mounted on a supporting wall 4 of the housing 7 by supporting springs 3. The control mechanism 93 is provided with focussing and tracking coils (not shown). The control mechanism 93 is also provided at both sides with two magnetic plates which are located opposite these coils. Therefore, the position of the position control mechanism can be controlled precisely by applying a current to the coils.

In order to reduce the coherence of the laser beam and to suppress laser noise, it is usual to superimpose a high frequency wave component on a driving electrical current supplied to the laser diode. This is because the output laser beam of the laser diode has excellent coherence, and when the laser beam which is reflected by the recording media etc, returns to the laser diode, the laser beams generate interference with each other inside the laser cavity and then, the gain of the laser oscillation fluctuates. As a result , the intensity of the output laser beam causes great noise. Therefore, it is necessary to reduce the coherence of the laser so as to suppress the noise. In order to achieve this, the high frequency wave component is superimposed on the driving current. For this, a laser noise reducing portion 5 is arranged beside the laser emission unit 20. Since noise is likely to leak out from the laser noise reducing portion 5, the laser noise reducing portion 5 is enclosed by a shielding case 95 to prevent any noise leakage therefrom.

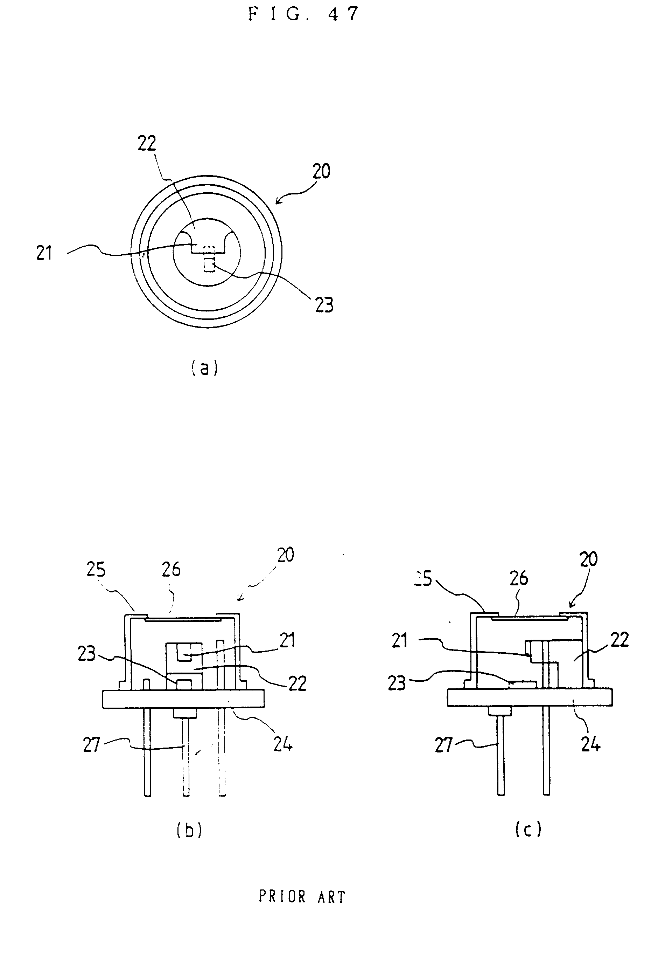

It may be possible to eliminate some of the above items from the optical head, or to adopt another method which is equivalent to the functions of some of the above items, in order to reduce the size of the optical head compared to that mentioned above. Referring to figure 47, another laser emission unit is shown, which has a different type of laser power detection portion which detects backwardly emitted laser beam for detecting the laser power. This laser emission unit is a canned type unit having a disk-shaped stem 24, a radiator 22 projected from the stem 24, a semiconductor laser (laser diode) 21 mounted on the top of the radiator 22, a cylindrical shaped cap 25 covering the stem 24 for protecting the laser diode 21 and the radiator 22, and a circular emitting window 26 positioned in a central portion of the cap 25. The laser diode is positioned just below the centre of the window 26 through which the laser beam is emitted. In addition, a laser power detection circuit 23 is disposed on the stem 24, by which the backwardly emitted laser beam is detected.

Where this laser emission unit is adopted, since the optical head is not provided with a laser power detection portion, it can be reduced in size by that amount. However, the power of a backward beam is not usually proportional to that of a forward beam. Therefore, in order to get an accurate power level, it is necessary to install a power detection portion similar to the conventional optical head shown in figure 46. Hence, up to now, there has not yet been developed an optical head having a small size while maintaining a high performance, such as resolution etc.

As mentioned above, it is important to get the smaller optical head in order to provide a still smaller optical memory device. However, taking the fact that data density becomes higher, performance of optical head cannot be degraded.

In Japanese Patent Publication No. 61280044, an optical head is described having a laser diode and detector both secured to a rigid housing. The output lens of the optical head is moved magnetically to focus the emitted laser beam.

Another optical head is schematically illustrated in an article titled "A High Frequency GaAs Multivibrator IC" in the GaAS IC Symposium Technical Digest 1988, in which an optical head comprising a laser driver and a laser detector is shown. However, no indication is given as to how focus and tracking of the emitted laser beam are to be controlled.

Therefore, it is an object of the present invention to provide an optical head of a smaller size than known hitherto without degrading the performance thereof. Yet, another object of the present invention is to provide an improved laser emission unit which is preferably applied to such a small-sized optical head.

The above and other advantages of the present invention will become apparent as the following description proceeds, and the features characterising the invention will be pointed out with particularity in the claims annexed to and forming a part of this specification.

According to the present invention there is provided an optical head for reading from and writing into an optical medium, comprising:
a laser diode for forwardly emitting a laser beam onto an optical medium from which the laser beam is reflected and returns as a returning beam;
signal detection means for detecting the returning beam for determining signals;
converging means for focusing the forwardly emitted laser beam onto the medium and for passing through the returning beam reflected from the optical medium;
position control means for finely controlling a focusing and a tracking of the forwardly emitted laser beam on the optical medium;
noise reduction means for superposing a high frequency wave component onto an externally supplied driving current for driving said laser diode and for reducing a coherence of the forwardly emitted laser beam; and
characterised by further comprising;
a movable lens holder including said laser diode, said signal detection means and said converging means, and having means arranged thereon for co-operating with said position control means magnetically and finely controlling its position so as to finely control a focusing and a tracking of the forwardly emitted laser beam on the optical medium; and
a housing, made of conductive material, accommodating said lens holder, said laser noise reduction means and connecting cables, and having a function of shielding noise from said noise reduction means.

Thus, according to the present invention there is provided a laser emission unit having a laser diode for emitting a laser beam and a signal detection means for detecting a reflected laser beam.

Adopting the above laser emission unit having some circuits in addition to the laser diode, it becomes possible to integrate a plurality of the functions which had been performed by the several portions distributed in the conventional optical head. For example, when the laser emission unit contains the signal detection circuit, a signal detection portion separately disposed in the conventional head, can be eliminated, and the size of the optical head of the present invention can be reduced easily. Furthermore, since the identical light path in the optical head is allocated for both an emitted laser beam and a reflected laser beam, the space necessary for the light path can be minimised and a smaller-sized optical head can be provided.

Similarly, adopting the laser emission unit containing the laser output power detection mean in addition to the laser diode, the size of the optical head can be reduced. However, in order to maintain the accuracy of detection of the emitted power as mentioned above, the laser emission unit of the present invention has the laser output power detection circuit detecting the forwardly emitted laser beam. This forwardly emitted laser beam is directed to the laser output power detection circuit, after the light path or a part thereof is changed. In order to change the light path of the laser beam, in the present invention, a reflecting portion is provided in the path of the laser beam for reflecting a part of the emitted laser beam. A prism for changing the light path of a major part of the laser beam emitted from the laser diode, may also be used for directing a part of the laser beam to the power detection circuit. Also, the laser output power detection circuit can detect a reflected beam from the diffraction grating. In this case, both the diffraction grating itself and a boundary area of the diffraction grating may be used for reflecting a part of the laser beam. It is also preferable to apply a reflecting coating, if the boundary area is used for reflecting. Adopting the laser emission unit having such a laser output power detection circuit as above, it is possible to eliminate the laser output power detection portion of the conventional optical head used for detecting the forwardly emitted laser beam. Therefore, the space allocated for such portion is also removed. The space of the light path for the emitted laser beam is commonly used for that of a partly reflected beam. Hence, the size of the present optical head can be reduced so much.

When the laser noise reduction circuit is included in the laser emission unit, the space for the laser noise reducing portion in the conventional optical head can be eliminated, and a smaller-sized optical head can be provided. In addition, when the laser noise reduction circuit is disposed in a smaller laser emission unit with the laser diode, the length of the connecting wire between the laser noise reduction circuit and the laser diode can be shortened. Therefore, there is an additional merit in that the amount of leaked noise from the wire can be minimised.

It is also possible to add another function to the laser emission unit, if a pre-amplifier circuit is disposed in the laser emission unit in addition to the above circuits, because the pre-amplifier circuit amplifies signals from the laser output power detection circuit and/or the signal detection circuit. Furthermore, the pre-amplifier circuit may have the functions for processing such detected signals so as to generate position error signals and the like.

It is possible to realise all of these circuits on the same semiconductor wafer, because all of the circuits, such as the laser output power detection circuit, the signal detection circuit, the pre-amplifier circuit, and the laser noise reduction circuit can be constructed or manufactured by the same semiconductor processes. Adopting the wafer containing these circuits for assembling of the laser emission unit, means that all the above circuits can be assembled in the unit at once, because most parts for assembling the laser emission unit can be realised when that wafer is disposed on the supporting portion of the unit. Therefore, productivity of the laser emission unit is excellent, and production cost is low. Further, it may be possible to install the laser diode on the same wafer prior to assembling of the wafer.

In addition to the advantage of reduction of the installation space as mentioned above, adopting the laser emission unit of the present invention, it is possible to reduce the space for allocating the light path and cabling in the optical head, because the laser emitting and receiving parts are integrated in the laser emission unit. Thus, the size of the optical head of the present invention can be reduced and a very small-sized optical head is provided. Also, since the laser emission unit of this invention is a multifunctional unit, the number of parts for assembling the optical head is so little and the number of assembling steps can be reduced. Therefore, the assembly cost of this optical head can be minimised. It may be further possible to decrease the positional deviation of parts arranged in the unit during the assembly process, and minimise the degrading due to the above positional deviation. Therefore, adopting the laser emission unit according to the present invention, it is possible to provide an optical head which is stabile and of higher quality. It may be preferable to put a plurality of the circuits of the above into the identical board or wafer and to assemble such board or wafer into the unit. Adopting the identical board, the optical head including the laser emission unit having the parts positioned precisely can be provided, and the performance of the optical head is maintained at a high level while the size of it can be reduced. Furthermore, the cost for the optical head can be reduced according to the present invention.

In accordance with the present invention, it may also be possible to pre-assemble with above laser emission unit into a lens holder having a positioning mechanism for focusing etc. In addition, the lens holder is provided with the diffraction grating and the objective lens. Because of integrating so many functions in the lens holders, the number of assembly parts for the optical head is decreased, the size of the optical head can be reduced and also the assembly costs and assembly time of the optical head can be reduced. Further, assembly error can also be decreased due to the reduced number of parts.

In order to shield from noise, if necessary for preventing or suppressing the leaked noise from the laser noise reduction circuit and/or the connecting wires attached thereto, the lens holder can be constructed of a shielding member. If the lens holder has the shielding ability itself, the leaked noise can be suppressed without any additional portion, such as shielding plate etc. It is preferable to use an electrically-conductive and non-magnetic material. For example a non-magnetic metal, an electrically conducting plastic etc., for the above shielding member, because in the lens holder, magnetic fields are used for its position control.

It is possible to dispose the laser reduction circuit in a shielding unit attached to the lens holder, and preferably it should be grounded (earthed) by a connection to an earth of the laser emission unit or that of the optical head. In order to prevent, if necessary, the leakage of noise from cabling installed between the laser noise reduction circuit and other outside circuits or equipment, such as means for supplying the laser driving current etc., a plurality of penetrating capacitors can be used. The capacitors are disposed penetrating the shielding portion of the lens holder or shielding unit. A plurality of low pass filters having an LC-network disposed in the lens holder or the shielding unit are also possible arrangements. The low pass filters have an advantage of low cost and they can be arranged in little space.

It may be possible to use the housing of the optical head as part of the shielding plate, in which the lens holder is disposed. It is also possible to cover the laser noise reduction circuit installed separately in the housing by another shielding plate or by other electrically conductive components of the optical head, in order to prevent noise to the pre-amplifier circuit, if required.

Another optical head of the present invention has a heat radiating mechanism, such a s radiator fins attached to the outside of the lens holding and/or ventilation holes on the housing wall, in order to get effective heat dispersion. Particularly for the smaller optical head, and especially one which is able to emit a high power laser beam, a high heat per unit volume is generated, it is preferable to adopt the heat radiation mechanism. In addition, it may be possible to vibrate the lens holder forcedly by the positioning mechanism itself, in order to spread out thermal energy. Furthermore, it may be possible to add some means for limiting the amount of the laser driving current or cutting off of the laser power.

The optical head according to the present invention may have a position limited or a stopper for limiting the distance to the optical medium in the direction of laser beam, in order to prevent troubles, such as destruction of the lens holder due to contacting the optical medium. Furthermore, the optical head of this invention may have a cover on the emitting port of the housing in order to make the housing dust proof and to protect the emission unit from malfunction.

Thus, the present invention provides not only a laser emission unit but also an optical head and an optical memory device having the advantages as discussed above.

The present invention will be described in detail in the following description of the preferred embodiments with reference to the attached drawings, wherein:
Figure 1 is a perspective partial view of an optical head according to a first embodiment of the present invention;
Figure 2 is a perspective partial view of a lens holder in the optical head of figure 1;
Figure 3 is a perspective partial view of a laser emission unit in the lens holder of figure 2;
Figure 4 is a partial plan view of a wafer in the laser emission unit of figure 3;
Figure 5 illustrates a light path of the optical head of figure 1;
Figure 6 is a block diagram showing circuitry of the optical head of figure 1;
Figure 7 is a block diagram showing current flow for driving the laser diode in the optical head of figure 1;
Figure 8 is a circuit diagram of a signal detection circuit, laser output power detection circuit, laser output power detection circuit and pre-amplifier circuit for the optical head of figure 1;
Figure 9 is a circuit diagram of a laser noise reduction circuit for the optical head of figure 1;
Figure 10 is a perspective partial view of a modified example of the optical head of the first embodiment of the present invention;
Figure 11 is a perspective partial view of an optical head according to a second embodiment of the present invention;
Figure 12 is a perspective partial view of a lens holder of the optical head of figure 11;
Figure 13 is a perspective partial view of a laser emission unit in the lens holder of figure 12;
Figure 14 is a flow diagram showing the control sequence for the optical head of figure 11;
Figure 15 is a perspective partial view of a modified example of the optical head of the second embodiment;
Figure 16 is a perspective partial view of another modified example of the optical head of the second embodiment;
Figure 17 is a perspective partial view of another modified example of the optical head of the second embodiment;
Figure 18 is a perspective partial view of another modified example of the optical head of the second embodiment;
Figure 19 is a perspective partial view of another modified example of the optical head of the second embodiment;
Figure 20 is a perspective partial view of another modified example of the optical head of the second embodiment;
Figure 21 is a perspective partial view of another modified example of the optical head of the second embodiment;
Figure 22 is a perspective partial view of a lens holder in the optical head of figure 21;
Figure 23 is a perspective partial view of an optical head of a third embodiment of the present invention;
Figure 24 is a perspective partial view of a modified example of the optical head of the third embodiment;
Figure 25 is a circuit diagram of low pass filter;
Figure 26 is a perspective partial view of another modified example of the optical head of the third embodiment;
Figure 27 is a perspective partial view of another modified example of the optical head of the third embodiment;
Figure 28 is an illustration of a light path of the optical head of figure 23;
Figure 29 is a plan view and sectional views respectively of the laser emission unit shown in figure 28;
Figure 30 is a plan view of a wafer in the laser emission unit of figure 29;
Figure 31 is a plan view and sectional views respectively of a modified example of the laser emission unit of the third embodiment;
Figure 32 is a perspective partial view of another modified example of the laser emission unit of the third embodiment;
Figure 33 is a perspective partial view of another modified example of the laser emission unit of the third embodiment;
Figure 34 shows another modified example of the laser emission unit of the third embodiment with a light path;
Figure 35 is a perspective partial view of the laser emission unit of figure 34;
Figure 36 is a plan view of a wafer in the laser emission unit of figure 35;
Figure 37 is a perspective partial view of another modified example of the optical head of the third embodiment;
Figure 38 is a perspective partial view of another modified example of the optical head of the third embodiment;

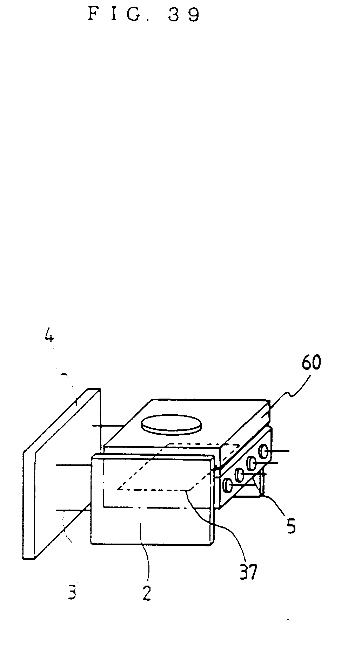

Figure 39 is a perspective partial view of another modified example of the optical head of the 3rd embodiment;
Figure 40 is an exploded perspective view of the optical head of figure 39;
Figure 41 is a perspective view of optical head of the figure 39 with its internal arrangement;
Figure 42 is a perspective view of the optical head of figure 39 with its side arrangement;
Figure 43 is a perspective partial view of another modified example of the optical head of the third embodiment;
Figure 44 is a perspective partial view of another modified example of the optical head of the third embodiment;
Figure 45 is a perspective partial view of another modified example of optical head of the third embodiment;
Figure 46 is a perspective partial view of a prior optical head; and
Figure 47 shows a partial plan view and partial sectional views respectively of a laser emission unit of the optical head of figure 46;

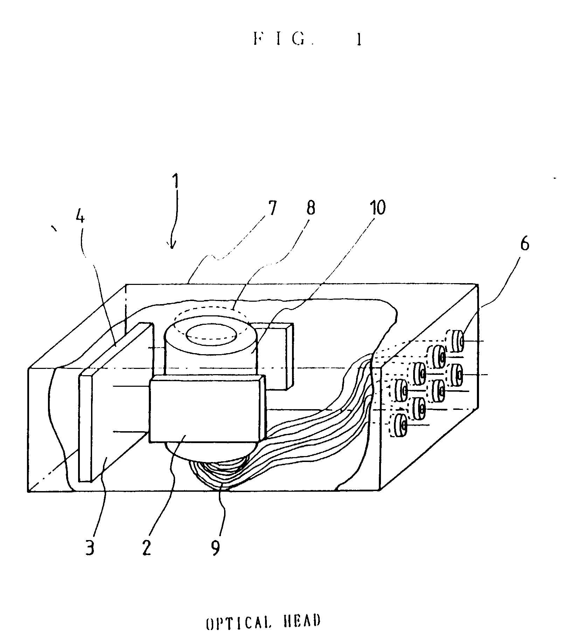

Figure 1 shows an optical head of a first embodiment in accordance with the present invention, wherein a housing of the optical head is illustrated partially broken away to reveal the inner structure of the optical head. The optical head 1 has a housing 7 of a generally rectangular shape, a round laser emitting port 8 disposed at the middle area of the upper surface of the housing 7. A laser beam passes through the port 8. The housing 7 shields any noise leaked from a laser noise reduction circuit, detail of which circuit will be described below. In order to shield the noise efficiently, the housing 7 is formed of conductive material so as to have its volume resistivity or specific resistance less than 4 x 10⁻³ Ω . cm. Also, it is preferred that the portion of the housing 7 formed by the conductive material, is connected with a ground potential of the optical head 1 or with an earth terminal of a laser emission unit, details of which unit will be described below. On the surface of such conductive material of the housing 7 an electric current is generated by the components of high frequency wave in the noise generated from the laser noise reduction circuit. Other components of the noise is transformed to thermal energy at the surface of the conductive portion. The current generated on the surface is absorbed into the ground and finally transformed to thermal energy. The conductive portion may be made of, for example, a metallic material such as aluminium, copper etc. Also, a conductive plastic, formed plastic with gilding or with a conductive coating an be used. If magnesium is adopted, then the housing can have both a high shielding ability and be extremely light weight.

The housing 7 has a supporting panel 4 fixed therein. Since an almost cylindrical-shaped lens holder 10 is elastically supported from the panel 4 by the spring 3, the lens holder 10 can moved sufficiently while it is accommodated in the housing 7. A pair of magnetic plates are located inside the housing 7 and at both sides of the lens holder 10. By these magnetic plates, a magnetic field is generated there as its to control the position of lens holder 10. In the lens holder 10, as described below, there is disposed a laser diode, the laser noise reduction circuit, etc. A plurality of interconnecting wire 9 extended from the lens holder in the housing 7, external to the housing 7 via a plurality of penetrating capacitors. Through the penetrating capacitors, the signal current, such as a driving current supplied from the laser driving circuit located exterior to the optical head 1 and the like are sent.

### LENS HOLDER

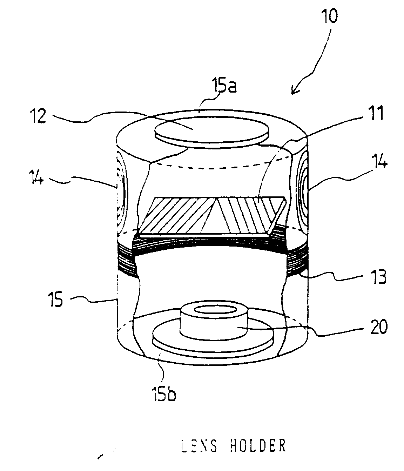

Figure 2 shows the lens holder 10 of this embodiment, wherein a holder cover 15 of the lens holder is illustrated partially broken away to reveal the inner structure of the lens holder. The holder cover 15 has a generally cylindrical shape. The holder cover 15 has an objective lens at a centre area of an upper disk shaped surface 15a, the laser emission unit is disposed on a bottom surface 15b of the holder cover 15 in which the laser diode and other circuits are disposed, and a diffraction grating 11 is disposed between the laser emission unit 20 and the objective lens 12. The holder cover 15 is provided on its cylindrical surface with a focusing coil 13 and tracking coils 14. The focusing coil 13 is coiled around an longitudinal centre axis of the cylindrical holder 10 and the tracking coils 14 are coiled around an transverse axis perpendicular to the above longitudinal centre axis.

A laser beam emitted from the laser emission unit 20 installed in the lens holder 10, is focused through the objective lens 12 onto an optical memory medium such as an optical disk. Optical disk is referred to as the optical memory medium in this specification hereinafter, but it is not intended to be limiting. A reflected laser beam contains data information and the like. The reflected laser beam from the optical memory medium is returned into the lens holder 10 via the objective lens 12 again. In the lens holder 10, the reflected beam is diffracted by the diffraction grating 11 and led into the laser emission unit 20.

The focusing coil 13 and the tracking coils 14 are installed on the lens holder 10 in order to control precisely the position of the lens holder 10 disposed between the magnetic plates 2. Position of the laser beam may be controlled by other means without the use of the coils 13 and 14, such as a track positioning control mechanism (not shown in the figures). In particular, other means may be used when the laser beam is transported over a large distance, for example, such as a seek operation of the optical disk. However, to detect the data stored on the optical disk, it is necessary to control precisely a focusing location and a tracking location of a detecting spot of the laser beam. In this lens holder 10, the focusing location can be finely controlled by the focusing coil 13 owing to a magnetic field generated by applied current to the focusing coil 13. This magnetic field generated from the coil 13 acts with a magnetic field of the magnet plates 2, and the position of the lens holder 10 along its longitudinal axis can be controlled. Also, the tracking location can be controlled precisely by the tracking coils 14 owing to a magnetic field generated by applied current to the tracking coils 14. The position of lens holder 10 along it's perpendicular axis as well as its longitudinal axis can be controlled by the cooperation between the magnetic field generated coils 14 and the field generated by the magnetic plates 2. After the optical head 1 is positioned at a certain place on a track having data marks to be read, the laser beam is controlled by the coils 13 and 14 so as to focus exactly on the data marks. Then the data marks on the optical disk is scanned by the laser beam and are read out.

Since the inner diameter of the emitting port 8 on the housing 7 is smaller than outer diameter of the lens holder 10, the lens holder 10 cannot be pushed out from the housing 7 if the position of the holder 10 is unexpectedly controlled to go beyond a limited span toward the optical disk. Since the window 8 serves as a stopper, the optical head 1 and lens holder 10 are free from troubles such as destruction of lens holder 10. Also, damage to the recording surface of the optical disk is prevented.

### LASER EMISSION UNIT

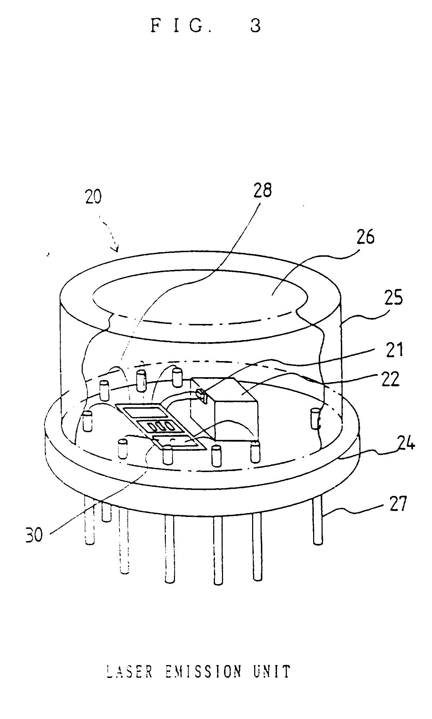

The laser emission unit 20 which is installed in the lens holder 10 of this embodiment is of a canned type. As shown in figure 3, the laser emission unit 20 comprises a disk-shaped stem 24, a radiator 22 projecting from the stem 24, and the semiconductor laser (laser diode) 21 disposed on the top of the radiator 22. The radiator 22 is disposed in order to prevent the laser diode 21 from any damage due to overheating. The laser diode including radiator 22, are protected by a cylindrical-shaped cap 25 against any physical damage. The cap 25 has a round window 26 at the centre of its upper surface, through which the laser beam is emitted from the laser diode 21.

On the stem 24 of this laser emission unit 20, there is provided a wafer 30 which includes a plurality of circuits, such as a signal detection circuit, laser output detection circuit, a pre-amplifier circuit and a laser noise reduction circuit. Also the stem 24 has a plurality of bar type electrodes 27 which penetrate through the stem 24 from inside to the outside of the laser emission unit 20. On the inside, the electrodes 27 are connected to other electrodes prepared on the wafer 30 via bonding wire 28. Outside of the unit 20, the electrodes 27 are connected to wire 9 which extends through the lens holder 10 as shown in figure 1. The laser diode 21 is connected to the wafer 30 via bonding wire 28.

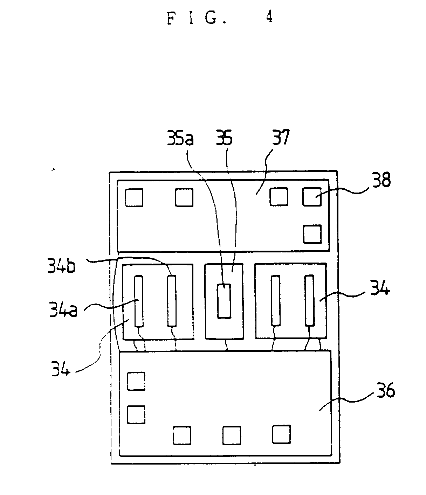

Referring to figure 4, the wafer 30 has a generally rectangular shape. The wafer is provided in its centre area with the laser output power detection circuit 35 including a photodiode 35a which is disposed at the centre of the circuit 35 for detecting the laser beam and for confirming the laser output power. The wafer 30 is provided, besides the output power detection circuit 35, with a plurality of the signal detection circuits 34 disposed oppositely in relation thereto. Each of the signal detection circuits 34 has a pair of photo diodes (34a, 34b) for detecting the returned beam. In addition, the wafer 30 has the pre-amplifier circuit 36 disposed on one end of the wafer 30, by which signals generated by the laser output power detection circuit 35 and/or the signal detection circuit 34 are enlarged. Also, the wafer 30 has the laser noise reduction circuit 37 disposed on its end, opposite to the pre-amplifier circuit 36, which are either side of the laser output power detection circuit 35. These circuits 34, 35, 36 and 37 are connected with the electrodes 27 or the laser diode 21 by the bonding wire 28 attached to the electrodes 38 installed on the wafer 30.

The laser output power detection circuit 35 detects a part of the laser beam emitted from the laser diode 21 forwardly, and it transforms the laser beam energy into a current signal. Although, there are some methods for changing the direction of the forwardly emitted laser beam toward the circuit 35, in the optical head described herein, a laser beam which is partly reflected from the diffraction grating 11, is used for the detection circuit 35. These details will be described below.

Signal detection photo diodes 34a and 34b detect the laser beam which is reflected from the optical disk, after being diffracted by the diffraction grating 11, and then transform such reflected beam energy to current signals. The signals generated by the signal detection circuit 34 are processed into signals for determining a value for positional error and recorded information.

The pre-amplifier circuit 36 translates the current signals generated from the signal detection circuit 34 and/or laser output power detection circuit 35 into voltage signals, and it amplifies the voltage signals up to sufficient level for sending them to other circuits, devices and the like. At the same time, since an output electrical impedance of the signals to be supplied is decreased in the pre-amplifier circuit 36, the signals can be prevented from being mixed with noise, and the band width does not decrease. In addition, the pre-amplifier circuit 36 can process the signals supplied from the photo diodes, and can generate some signals such as focusing position differential signals, recorded data signals and other signals. Since the pre-amplifier circuit 36, the output power detection circuit 35 and signal detection circuit 34, are disposed on the same wafer 30, as viewed in figure 4, the length of wire connecting these circuits together is very short. Therefore, any possibility of the signal being mixed with noise, which could occur while the signals come to the amplifier circuit 36, can be reduced even further.

The laser noise reduction circuit 37 having a high frequency generator and a buffer amplifier, superimposes a high frequency wave component on the driving current for driving the laser diode 21 before the driving current is supplied to an anode (or hot side) of the laser diode 21. If the high frequency wave component is superimposed on the driving current, the value of the driving current is modulated over a short period. Hence, the wavelength of the emitted laser beam is altered in accordance with the modulation of the driving current, and the coherency of the laser beam can be decreased. So, laser noise due to the reflected beam can be suppressed. In the laser emission unit 20 shown in Fig. 3, since the laser noise reduction circuit 37 is mounted on the wafer 30 and is installed beside the laser diode 21, the length of connecting wire between the laser diode 21 and the circuit 37 is shortened and the surface area through which the noise may leak can be decreased.

As mentioned above, the laser emission unit 20 shown in Fig. 3 has the wafer 30 disposed in the unit 20, and on the same wafer 30, four circuits such as the output power detection circuit 35, the signal detection circuit 34, the pre-amplifier circuit 36 and the laser noise reduction circuit 37, are arranged. It is not necessary to install several independent portions in the optical head in order to perform the functions of the above four circuits. Therefore, the arrangement of the optical head becomes very simple, and the size of the optical head can be reduced. In addition, the productive cost can be reduced. Since the four circuits 34, 35, 36 and 37 can be made on the same wafer by the same semiconductor manufacturing process, manufacturing time and cost can be decreased in comparison with that of the conventional optical head in which a plurality of portions for performing the above four circuits are located separately. In addition, since a small number of parts are necessary for assembling the optical head, it can be assembled by less steps than those for manufacturing the conventional optical head. Thus, the assembly of this optical head becomes easy.

Since the photo diode 35a for detecting the laser output power and the photo diodes 34a and 34b can be manufactured by semiconductor process on the wafer, the diodes 35a, 34a and 34b can be realised on the wafer with a high accurate relative location, shape and dimension. In order to install these circuits in the small laser unit 20, it is preferred to keep the relative distance accurately. Hence, the wafer shown in figure 4 is most adaptable to the small sized laser unit 20 of this invention, because on the wafer a plurality of the circuits are made by the same semiconductor processes. Moreover, when adopting the wafer having these circuits, it is then very easy to keep the predetermined location accurate during the assembly of the laser unit. Therefore, using the wafer in which several functions are integrated, the performance of the laser emission unit can be higher and more stabilised. Also, a small optical head with high accuracy and high performance can be provided.

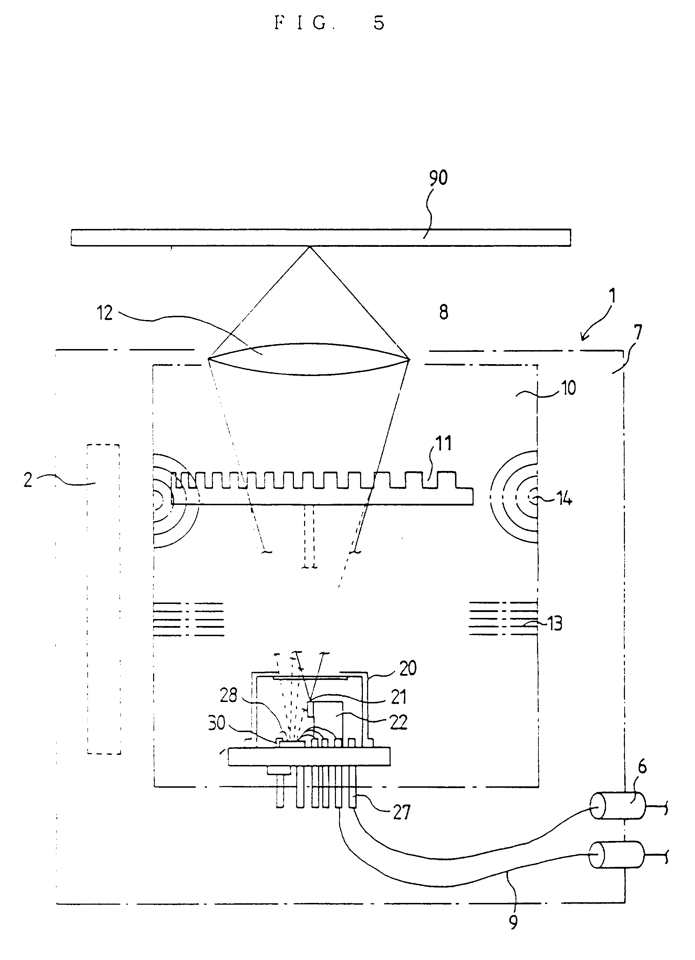

In figure 5, the arrangement of the optical head of the first embodiment is illustrated. The laser beam goes through the diffraction grating 11 after it is emitted from the laser diode disposed in the laser emission unit 20, then it passes the objective lens 12 and the emitting port 8 of housing 7 sequentially. Finally the laser beam is focused on the recording surface of an optical disk 90. Since the surface, opposite to the diffraction surface having the diffraction grating 11, has no anti-reflection meaning such as an anti-reflection coating and has approximately 4% reflectivity, a part of the laser beam emitted from the laser diode is reflected to the laser emission unit 20. In the laser emission unit 20, the above reflected beam is detected by the photo diode 35a located in the laser output power detection circuit 35. Since the laser output power detection circuit 35 can detect a part of laser beam emitted forwardly from the laser diode 21, the power which is actually focused on the disk can be confirmed accurately.

The laser beam is introduced again into the lens holder 10 passing the emitting port 8 of housing 7 after it is reflected from the data mark located on the optical disk, via the objective lens 12 of the lens holder 10 inversely. This reflected beam is diffracted by the diffraction grating 11, and then it is astigmatically converged on the photo diodes 34a and 34b in order to detect the beam containing the position error signal and storage data signal on the surface of the optical disk.

The reflected returned beam is detected by the photo diodes 34a and 34b, then it is changed to current signals. The current signals are amplified and processed by the pre-amplifier circuit 36 and then they are transferred to outside of the optical head 1 via the bonding wire 28, the electrodes 27, the cable 9 and penetrating capacitors 6.

The driving current for driving the laser diode 21 is supplied from outside of the optical head 1 to the laser noise reduction circuit 37 arranged on the wafer 30, via the penetrating capacitors 6, the cable 9, electrodes 27 and bonding wire 28 sequentially. The driving current is supplied to the laser diode via the bonding wire 28, after the high frequency wave component is superimposed on it at the laser noise reduction circuit 37.

Referring to figure 5, as mentioned above, the laser emission unit 20 is provided therein with not only the laser diode 21 but also the laser output power detection circuit 35, the signal detection circuit 34, the pre-amplifier circuit 36 and the laser noise reduction circuit 37. Therefore, the size of the optical head 1 according to this invention becomes much smaller than that of the conventional head in which a plurality of portions which provide the same functions as the above circuits are arranged separately. Also, the optical head of this invention has advantages that minimises production cost and time, and upgrades the quality because it can be assembled from a small number of parts. In addition to the above merits, since the functions of emitting and receiving the laser beam are integrated in the laser emission unit, the path for the laser beam, namely the light path of the emitting beam and that of reflecting beam, can be commonly allocated in the lens holder and optical head. Therefore, a space for the light path can be reduced. Hence, the size of the optical head is able to be much smaller. Further, since a part of the emitting laser is reflected by the diffraction grating and the path of this reflected beam can be shared with that of the emitting beam, the space for the light path is further reduced and an even smaller optical head can be provided.

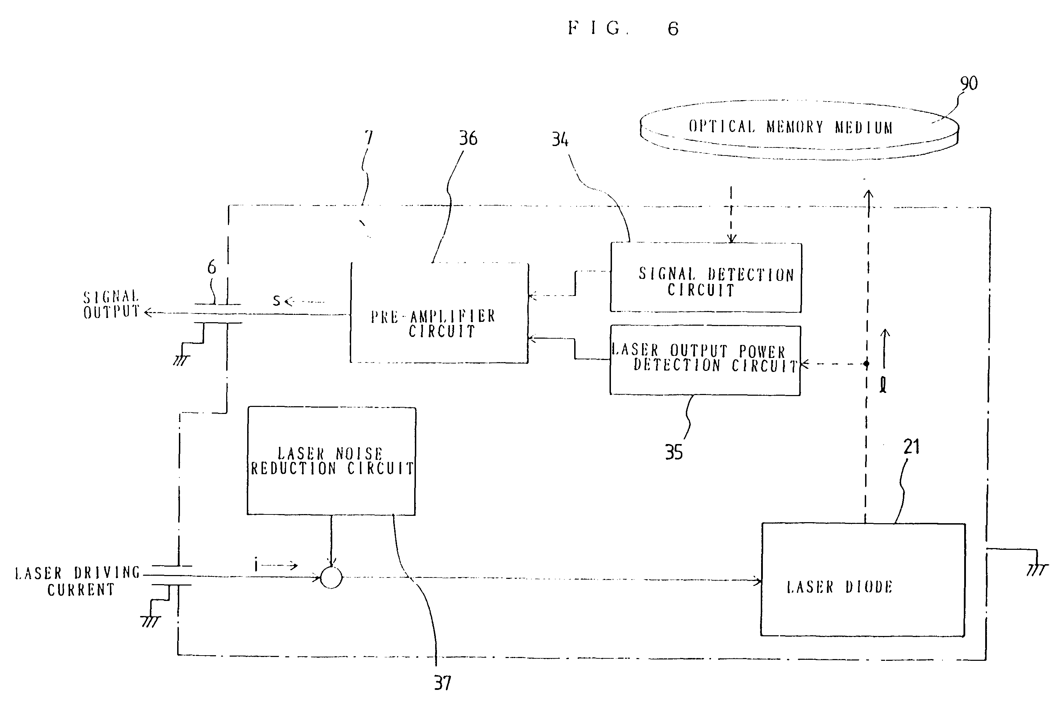

Figure 6 is a block diagram of circuits for the above optical head 1. The laser diode driving current i is supplied from a laser driving circuit (not shown in this figure) to the laser diode after superimposing the high frequency wave generated from the laser noise reduction circuit 37. The diode 21 is driven by this superimposed current, and the laser beam *l* is emitted. Part of the laser beam *l* is reflected at the diffraction grating 11 and the power of the laser beam is signalled by the output power detection circuit 35. On the other hand, the data beam reflected from the optical disk is signalled by the signal detection circuit 34. Output signals from the power detection circuit 35 and the signal detection circuit 34 are supplied downstream after they are amplified and transferred from current to voltage signals in the pre-amplifier circuit 36 so as to be more manageable for some downstream circuits. Also, the pre-amplifier can generate the position error-differential signals and other storage information signals from the optical medium. These circuits are enclosed by the housing 7. Cabling 9 extends outside the housing 7 passing through the penetrating capacitors 6 formed on the wall of the housing 7. Therefore, any noise leaked out from the laser noise reduction circuit 37 can be shielded, and their influence on other devices and/or equipment is minimised.

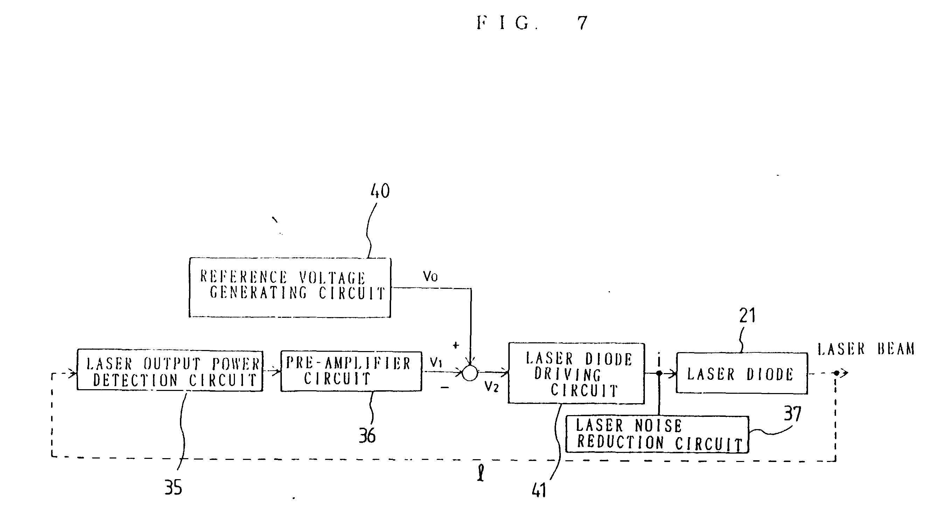

Figure 7 illustrates a control mechanism for the laser power using the power detection circuit 35. First, a reference voltage V₀ is generated from a reference voltage generating circuit 40. The current signal generated from the laser power detection circuit 35 is changed to a voltage signal at the pre-amplifier circuit 36. This voltage signal is inverted and the inverted signal having a value of output voltage V₁, is generated. Then, the voltage V₁ is added on the reference voltage Vₒ and a laser control signal voltage V₂ is made. This laser control signal V₂ is supplied to a laser diode driving circuit 41 where the laser driving current i is generated in accordance with the laser control voltage V₂. As mentioned previously, the driving current i is supplied to the laser diode after it is superimposed with the high frequency wave component supplied from the laser noise reduction circuit 37. Then, from the laser diode, the laser beam is emitted in accordance with the value of the driving current i. A part of the laser beam is again detected by the laser power detection circuit 35.

When the power of the laser beam is superior to a predetermined value, the amount of the current signal generated from the laser power detection circuit 35 is increased. Then, the voltage V₁ which is the inverse of the voltage signal sent from the pre-amplifier circuit 36, is decreased. Hence, the laser output control signal V₂ is also decreased, and in accordance with the voltage V₂, the driving current i becomes low. Therefore, the power of emitted laser beam is decreased according to the current i.

On the contrary, when the power of the laser is inferior to the predetermined value, the inverse voltage V₁ is increased and the voltage V₂ is also increased. In accordance with the value of voltage V₂. the amount of the laser driving current i is increased, then the power of the laser beam emitted from the laser diode is increased. As explained, the control system disclosed in figure 7 has enough ability to control the laser power so as to keep the laser power constant by referring to the predetermined value V₀.

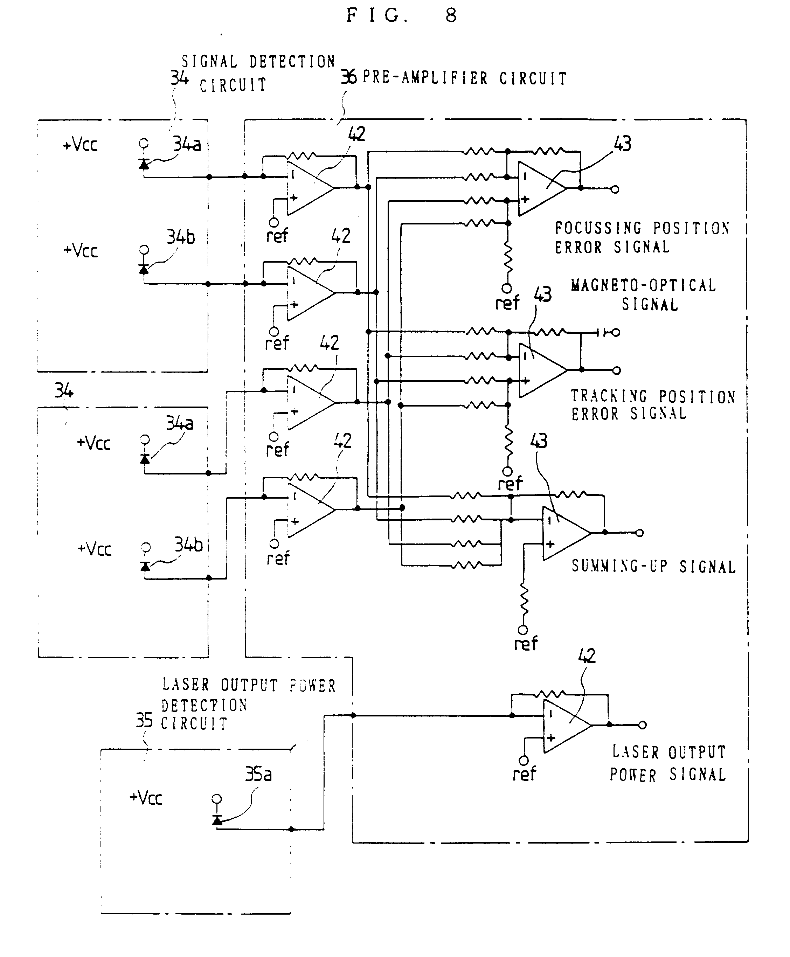

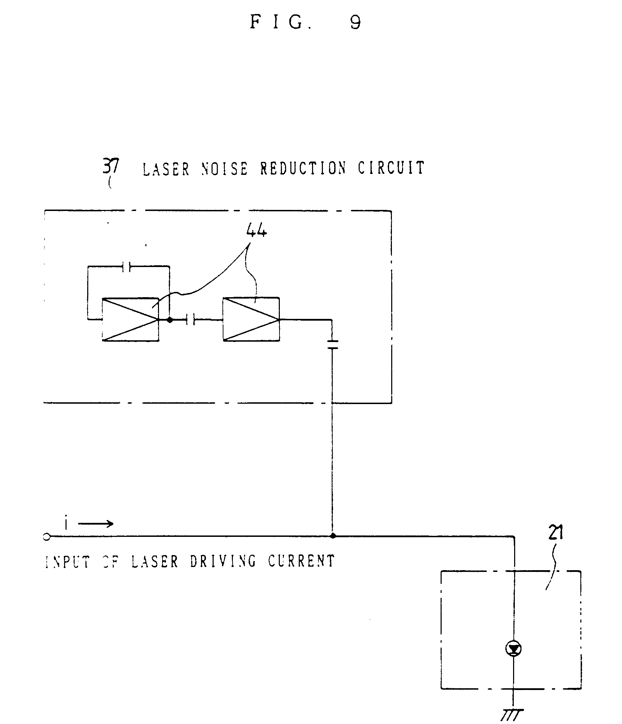

In figures 8 and 9, there is shown the arrangement of each circuits 34, 35, 36 and 37. Each of the two signal detection circuits 34 has two photo diodes 34a and 34b respectively each of which is connected to a high voltage V_{cc}. The power detection circuit 35 has a photo diode 35a to which the high voltage V_{cc} is connected.

Referring to figure 8, the pre-amplifier circuit 36 generates position error signal and the like. The current signals from all of the four photo diodes 34a and 34b are supplied to three operational amplifiers 43, after being transferred to voltage and amplified by four operational amplifiers 42. In the pre-amplifier circuit 36, an error signal for focusing position is generated by the astigmatism method, and an error signal for tracking position is generated by the push-pull method. The circuit 36 makes and sends out a recording signal stored in the optical disk and a signal containing total intensity. If a magneto-optical disk is used, then a magneto-optical recording signal is stored.

Referring to figure 9, the laser noise reduction circuit 37 has a high frequency wave generator and a buffer amplifier, each of which consists of a high frequency band amplifier 44. The output from the laser noise reduction circuit 37 is added through a capacitor to the driving current i for driving the laser diode. The driving current with high frequency wave component is supplied on an anode (hot side) of the laser diode 21.

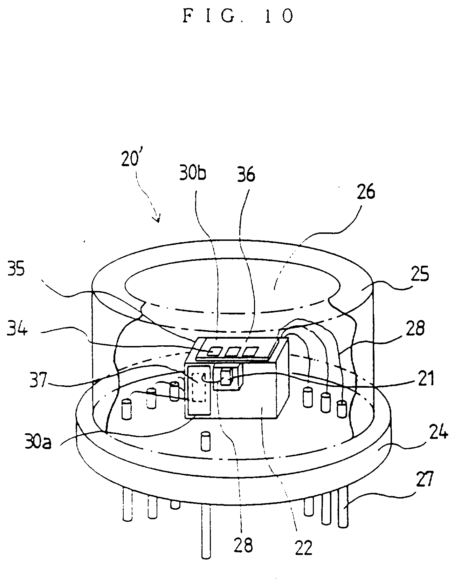

Figure 10 shows a modified example of the laser emission unit 20' which can be installed in the above mentioned lens holder 10. The laser emission unit 20' has a wafer 30a containing the laser output power detection circuit 35, the signal detection circuit 34 and the pre-amplifier circuit 36. The laser emission unit 20' has another wafer 30b containing the laser noise reduction circuit 37. The wafer 30a containing the circuits 34, 35 and 36 is disposed on top of the radiator 22. The wafer 30b containing the circuit 37 is disposed on side of the radiator 22 next to the laser diode 21. Due to this arrangement, the bonding wire 28 is more easily connected between the wafers 30a, 30b and electrodes 27. Since the distance between the laser diode 21 and the laser noise reduction circuit 37 becomes shorter and also the length of bonding wire 28 connecting the above circuit 37 and the diode becomes shorter, the amount of noise which leaks from the circuit 37 can be reduced.

### HOUSING OF AN OPTICAL HEAD OF THE SECOND EMBODIMENT

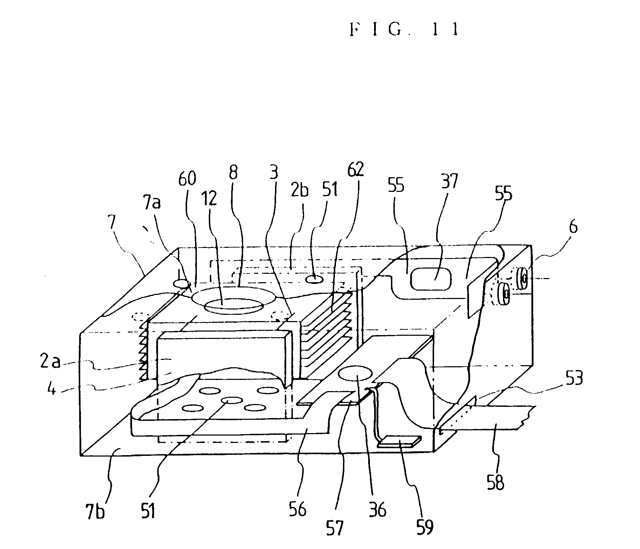

Figure 11 shows an optical head of a second embodiment according to the present invention, wherein a housing 7 and supporting panel 4 of this optical head 1 are partly broken away to disclose the internal arrangement of the optical head 1. The housing 7 of the optical head 1 has a generally rectangular shape and provides shielding for noise, the same as the housing of the first embodiment. In addition, the present housing 7 has a plurality of ventilating holes 51 on an upper surface 7a and lower surface 7b. In the housing 7, there is provided a lens holder 60 having a generally rectangular shape, and supporting panels 4 for supporting the lens holder 60. By the panels 4, magnetic field is generated around the lens holder 60, therefore, the panels 4 serve as magnetic plates 2a and 2b. Since the lens holder 60 and supporting plates 4 are jointed by an elastic means such as the spring 3, the lens holder 60 can move flexibly, and the position of the lens holder is controlled finely. A laser emitting hole 8 is allocated above an objective lens 12 on the lens holder 60, and the diameter of the hole 8 is smaller than the outer dimension of the lens holder 60. Therefore, the hole 8 can stop the lens holder 60.

The lens holder 60 is provided with a plurality of radiator fins 62, each having a generally rectangular shape, on its oppositely arranged side panels, a flat cable 55 extended from lens holder 60 through an area between the housing 7 and one of the magnet plates 2b, and the laser noise reduction circuit 37 is disposed on the cable 55. The cable 55 containing the laser noise reduction circuit 37 extends up to a side wall of the housing 7 and is connected with a plurality of penetrating capacitors through which another wire extends outside of the housing 7.

From the lens holder 60, another flat cable 56 extends through an area between a side panel of the housing 7 and the other magnetic plate 2a. The flat cable 56 is connected with a board 57 disposed in the housing 7, and the pre-amplifier circuit 36 is arranged on the board 57. Output cable 58 from the pre-amplifier circuit 36 extends outside of the housing 7 through a slit 53 formed on a side panel of the housing 7. In the housing, a temperature sensor 59 is disposed and connected with the output cable 58 via the board 57.

Since the optical head 1 of this embodiment has ventilation holes on the housing, and the lens holder 60 has the radiator fins 62 thereon, any temperature rise due to heat generated from the laser emission unit (which will be specified later) can be suppressed within a limited range. It is preferable for smaller optical head to keep the temperature rise below the limited value, because the temperature of the small optical head is intended to be relatively high due to the heat generated in laser unit. Especially, for an optical head using a laser unit capable of emitting high powered laser beam, it should be desirable to prepare some means for radiating the heat accumulated therein and to prevent any malfunction which may happen owing to the degraded performance of the laser diode or other circuits due to the high ambient temperature. In addition, the optical head 1 has another heat radiating method. In this heat radiating method, the internal temperature of the housing is observed by the temperature sensor 59 and when the internal temperature exceeds a predetermined value, the lens holder 60 is forcibly vibrated for further cooling. This cooling method will be explained later.

Since the pre-amplifier circuit 36 is disposed on the board 57 in the housing 7 and not disposed in a laser emission unit, tuning of the pre-amplifier circuit 36 can be done easily when fine tuning is required due to the reasons of amplifying or generating signals from the laser power detection circuit or the signal detection circuit. Similarly, tuning of the laser noise reduction circuit can be done easily. In these cases, the circuits located in the housing 7 can be arranged either on the board, the same as the pre-amplifier circuit, or on the flat cable, the same as the laser noise reduction circuit. Installation space can be reduced if the circuits are arranged on a flat cable, because the flat cable can be flexibly disposed, which is particularly useful in complicated shaped areas.

### LENS HOLDER

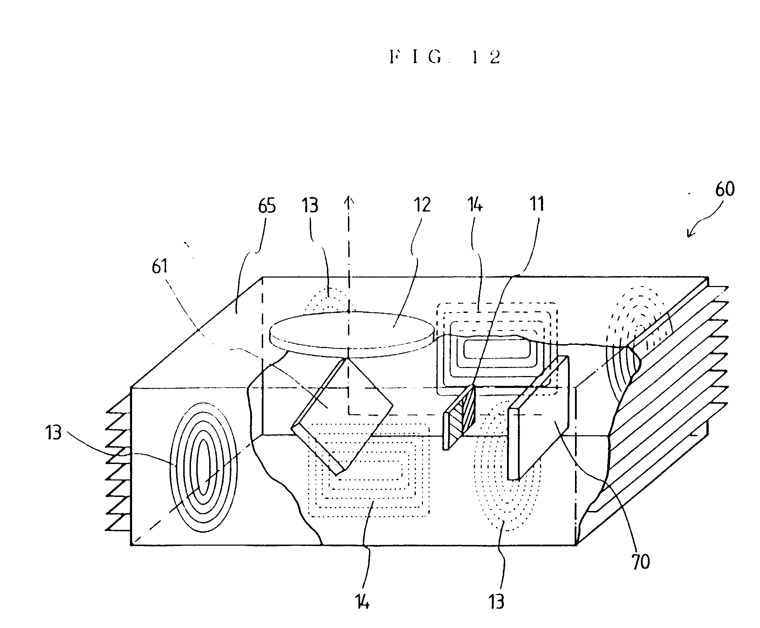

Referring to figure 12, a lens holder 60 disposed in the above optical head 1 has a holder cover 65 of a generally rectangular shape containing the objective lens 12 on its upper wall the plurality of radiation fins 62 on its opposite side walls. In addition, the lens holder has focusing coils 13 and tracking coils 14 both of which are disposed on longer side surfaces of the cover 65 facing the magnetic plates 2a and 2b respectively. In the holder cover 65, there is arranged a laser emission unit 70 rectangularly shaped having the diffraction grating 11 and the mirror 61.

A laser beam emitted from the laser emission unit 70 goes through the diffraction grating 11, and the light path of this laser beam is changed upward by the mirror 61 before the laser beam is passed through the objective lens 12. On the contrary, a reflected laser beam from an optical disk or other optical memory medium, is introduced into the laser emission unit 70 by the same light path but inversely, namely through the path which sequentially contains the objective lens 12, the mirror 61 and the diffraction grating 11. The reflected laser beam is astigmatically converged on the laser emission unit 70, the same as the first embodiment described before. Also, in the same manner as the optical head of the first embodiment, the position of the lens holder 60 can be controlled precisely by the focusing coils 13 and tracking coils 14. In the lens holder 60 of this embodiment, the laser emission unit 70, the diffraction grating 11 and mirror 61 are arranged in line along with the longitudinal direction of the lens holder 60: the direction of which is perpendicular to the direction of the laser beam to be emitted from the lens holder. Therefore, the thickness of the lens holder along the direction of the emitted laser beams can be reduced. Hence, the thickness of the optical head can be reduced and the total dimension of the optical head is relatively little.

### LASER EMISSION UNIT

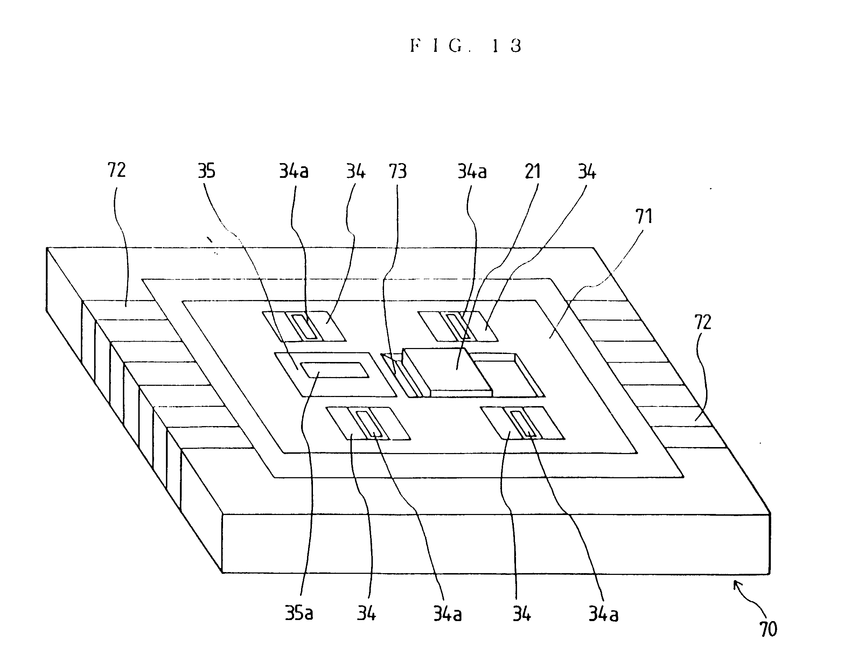

Referring to figure 13, the laser emission unit 70 described above, has a wafer 71 which has a generally rectangular shape, containing a plurality of terminals 72 disposed around the wafer 71, and the laser diode 21 disposed on a central area of the wafer 71. Also, the wafer 71 has the laser output power detection circuit 35 containing the power detecting photo diode 35a arranged on a central area of the wafer 71 besides the laser diode 21, four signal detection circuits 34 containing signal detecting photo diodes 34a arranged on both sides of the wafer 71 in line with the laser diode 21 or the power detection circuit 35, and a reflection surface 73 arranged between the laser diode 21 and the laser power detection circuit 35 for vertically changing the light path of the laser beam emitted from the laser diode 21.

The direction of the laser beam emitted from the laser diode 21 is changed before being emitted perpendicularly to the plane of the laser emission unit 70 corresponding to the wafer 71. The laser output power detection circuit 35 detects a part of the reflected laser beam from the diffraction grating 11, the same as the first embodiment. The signal detection circuit 34 detects the reflected laser beam which passes through the diffraction grating 11, after the beam has been reflected at the optical disk and returned via the light path mentioned above. In this embodiment, the signals from the signal detection circuits 34 and the laser power detection circuit 35 are sent to the pre-amplifier circuit 36 disposed outside of the laser emission unit 71 via the terminal 72 and the like. In the pre-amplifier circuit 36, the current signals are transformed to a voltage and generated. On the other hand, a laser driving current is supplied to the laser diode 21 on the wafer 71 by way of the laser noise reduction circuit 37 via the flat cable 55 and terminals 72, and by that current the laser diode can be driven.

Since the laser emission unit 70 contains the circuits 34 and 35 with the laser diode 21 on the same wafer 71, the lens holder 60 and optical head 1 having this unit 70 can be assembled easily in a short time, and the manufacturing costs of the unit 70 can be reduced. Because the laser emitting part (laser diode 21) and laser receiving parts (photo diodes 34a and 35a) are assembled on the same wafer 71, the relative between these parts can be precisely controlled during manufacturing. Thus, the accuracy of the laser emission unit will be fine and the quality of the laser emission unit can be fairly stable. Although the pre-amplifier circuit 36 and the laser noise reduction circuit 37 are disposed outside of the laser emission unit 70, both of them or each of them can be assembled on the wafer 71.

Since the laser emission part and laser receipt parts are integrated on the laser emission unit 70, the length of the light path in the lens holder 60 and optical head 1 can be minimised and the smallest-sized optical head can be provided. Especially in this embodiment, the thickness of the optical head is very thin, because of the thin-sized lens holder 60 which is used. Further, since the pre-amplifier circuit 36 and the laser noise reduction circuit 37 are disposed in the housing 7 but are disposed out of the laser emission unit 70, the tuning of these circuits can be done easily: If necessary, due to such means as some deviation of each laser diode etc., dividing manufacture. In the optical head 1 of this embodiment a flat cable is applied and so cabling can be done flexibly in any space, and on which some circuits can be arranged. Therefore, some spaces can be eliminated which have previously been required for cabling, connecting or installation of the circuit boards. Thus, the size of the optical head can be minimised. In addition, in this embodiment, these cables are actually shielded from each other because the lens holder 60 and magnetic plates 2a and 2b are disposed in the space between these cables. Therefore, the pre-amplifier circuit 36 is relatively free from noise generated in the laser noise reduction circuit 37. This arrangement may be preferable when the noise power from the laser noise reduction circuit 37 is so high, or that the pre-amplifier circuit 36 cannot tolerate a weak noise because of factors such as a higher data density which is to be read and/or written.

In this embodiment, the lens holder has the heat radiation fins 62 so as to increase the surface area which contacts the air to get effective heat radiation, and also the housing 7 has the ventilation holes. The optical head 1 having these arrangement is preferred when emitting a high power laser beam, because the excess temperature rise can be reduced at the lens holder 60, the laser noise reduction circuit 37 and the pre-amplifier circuit 36.

In the optical head 1, the lens holder 60 is always moved up and down according to the deflection of the optical disk in order to focus the laser beam by the position control mechanism. For example, in an optical memory disk device, the lens holder 60 is moved up and down along the direction of the laser, at the same time as the periodic movement of the surface of the optical disk. Owing to such actions of the lens holder 60, the air in the housing 7 becomes mixed and the heat which is generated is absorbed by the air. At the same time, the air in the housing is exchanged via ventilating holes. Therefore, the temperature rise in the housing 7 can be suppressed within the limited range. It is preferable to use magnesium for forming the housing 7 to get more effective heat radiation, because magnesium has a low weight and high thermal conductivity.

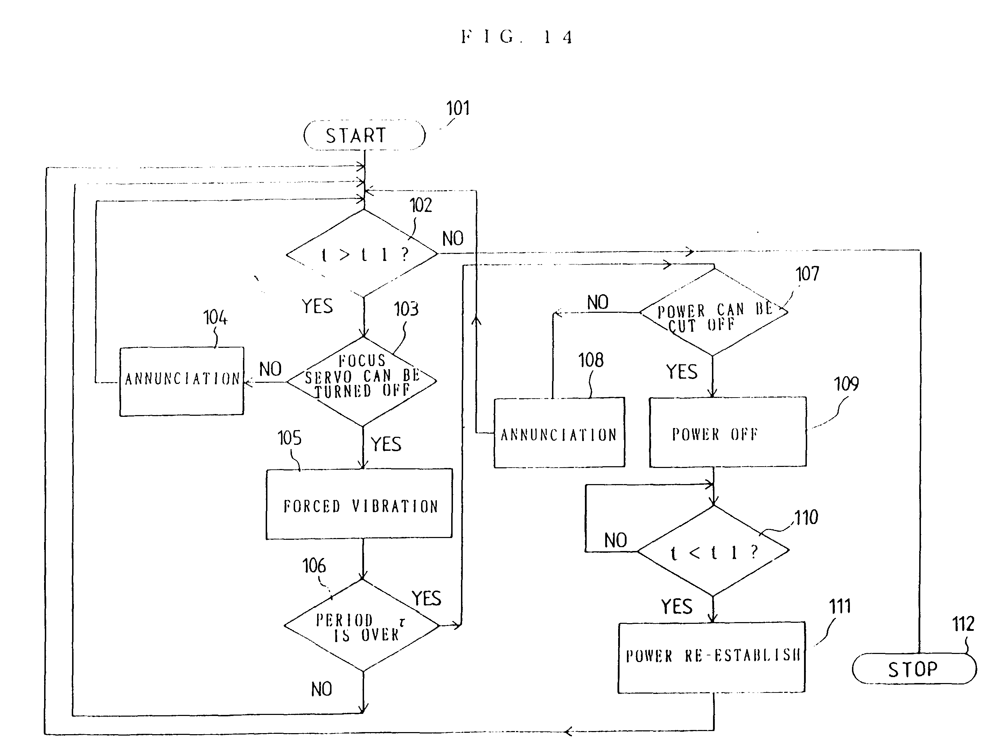

Furthermore, the optical head of this embodiment has a method for reducing the temperature rise, in which the lens holder 60 is forced to vibrate in accordance with the temperature observed. Figure 14 shows the control sequences.

At a step 101, the sequence of temperature control is started. At a step 102, the temperature t of the optical head is detected and whether the temperature t exceeds a predetermined limited value t1. The temperature t is the ambient temperature of the optical head housing 7 and it is measured by the temperature sensor 59. If the temperature t is below the value t1, then the sequence moves to step 112 and quits.

If the temperature t is larger than the limited value t1, a judgement is made at step 103 in order to confirm whether the focusing servo can be turned off or not. In an optical memory device, the focusing servo is required for data writing and/or reading, but it is not necessary in any other state and so it is possible to turn it off. If the focusing servo cannot be turned off due to some operating state of the device, it is impossible to let the lens holder 60 go into a forced vibrational mode. So at step 104, a warning is shown and the sequence returns to step 102 where the temperature t is still observed.

If the focusing servo can be turned off, at step 105, the lens holder 60 is forced to vibrate by the focusing servo mechanism such as coils and magnetic plates, in order that the air in the housing becomes mixed and the temperature t on the inside of the housing is decreased. Up to a period τ, the lens holder 60 is kept in forced vibrational mode. During this period, the time interval is judged at step 106 and the temperature t is continuously evaluated at step 102. When the temperature t is below the limited value t1, the control sequence is moved to step 112 and the lens holder 60 is freed from the forced vibrational mode.

After the period τ, if the temperature t is still higher than the limited value t1, at step 107, the sequence checks whether the electrical power supplied to the laser noise reduction circuit 37 can be cut off. Namely, the judgement is done whether the pre-amplifier circuit 36 and lens holder 60 can be stopped or not. If the electrical power can be stopped, it is possible to let these circuits halt and the heat generated from these circuits can be decreased.

If the electrical power cannot be cut off, at step 108, the sequence displays a warning, and then returns to step 102 or does some possible action such as observing the temperature t and putting the holder into forced vibration.

When the electrical power can be cut off, at step 109, the supply of the electrical power is stopped by the sequence. Then at step 110, the temperature t is supervised until the temperature t is below the limited temperature t1, at step 111, the electrical power is turned on, then the sequence returns to step 102 where the temperature t is observed.

Although, not shown in the flow chart in figure 14, it is possible to set another limited value t2 which is higher than the limited value t1. In this case it may be possible to apply a control that as soon as the temperature t exceeds the limited value t2, the electrical power supplied to the optical head, is turned off. This sequence is preferable to prevent the destruction and miss operation of the optical head due to excessive temperature rise.

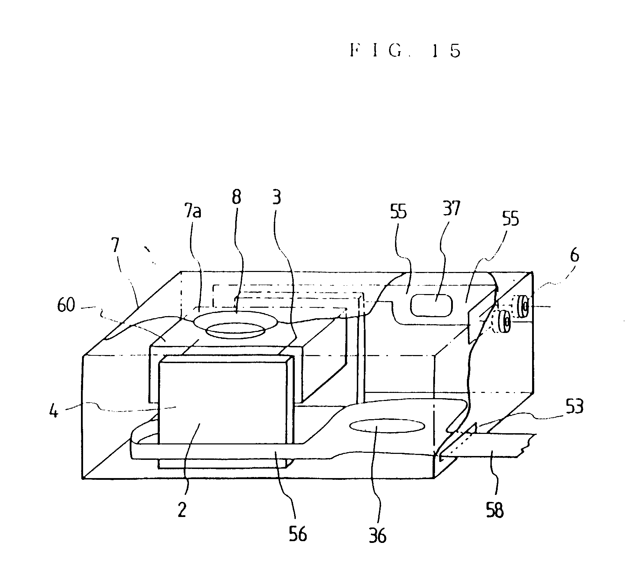

In figures 15 through 21, there are shown some modifications of the optical head 1 of this embodiment. In figure 15, a modified optical head 1 is shown which has the pre-amplifier circuit 36 disposed on the flat cable 56. Thus, connection work between the cable and the pre-amplifier circuit 36 can be eliminated and assembly time can be saved. There is the additional merit in that the space necessary for the circuit 36 can be reduced.

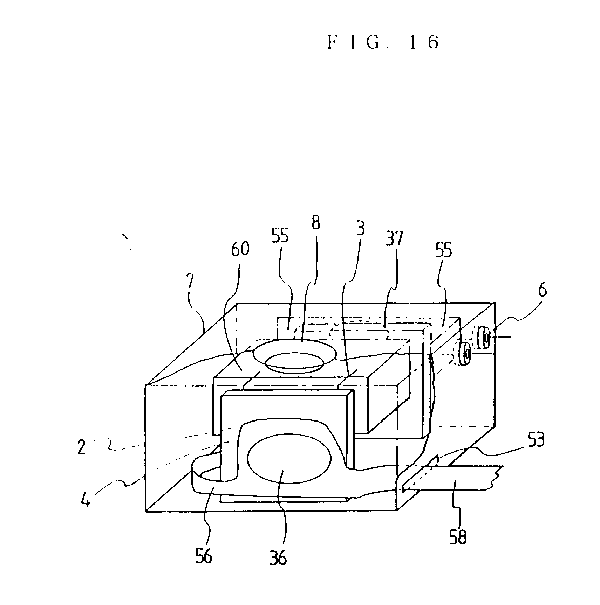

In figure 16, another modified optical head 1 is shown which has the laser noise reduction circuit 37, disposed on the flat cable 55, and located between the side wall of the housing 7 and the magnetic plate 2b, and the pre-amplifier circuit 36, disposed on the flat cable 56, and located on another side wall of the housing 7 and the other magnetic plate 2a oppositely arranged to the plate 2b. Therefore, the lens holder 60, magnetic plates 2a and 2b all of which serve shielding are provided between the laser noise reduction circuit 37 and the pre-amplifier circuit 36, and so these circuits are electrically and magnetically isolated. Accordingly, by the lens holder 60 and magnetic plates 2a, 2b, interference between the circuit 36 and circuit 37 can be reduced. Therefore, the optical head 1 shown in figure 16 is preferred to that for treating a signal which is intolerant of noise. In this optical head 1, since the circuits 37 and 36 are installed between the housing 7 and the magnetic plates 2a, 2b, an even smaller sized optical head can be provided.

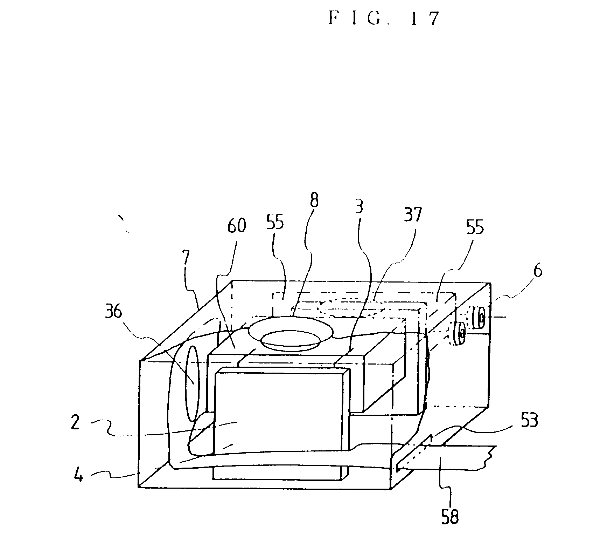

In figure 17, another modified optical head 1 is shown which has the pre-amplifier circuit 36 disposed on the flat cable 58, and located near the lens holder 60: the pre-amplifier circuit 36 is disposed also near one of the side walls of the housing 7 but not near either of the magnetic plates 2a, 2b. According to the above arrangement, the length of the flat cable connecting the pre-amplifier circuit 36 and the lens holder 60, can be shorter, and any possibility of catching noise on the signal sent by the cable 58 is reduced. Thus, there is the merit in that the pre-amplifier circuit can get a relatively clear signal having low noise.

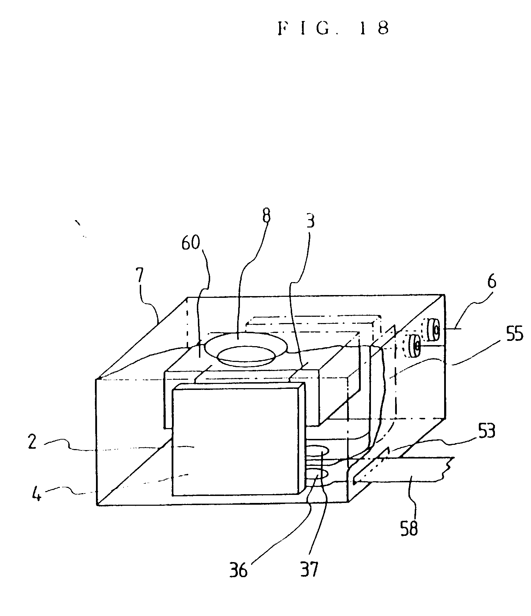

Referring to figure 18, another modified optical head has the laser noise reduction circuit 37 disposed on the flat cable 55 and the pre-amplifier circuit 36 disposed on the flat cable 58: both of which are arranged under the lens holder 60. According to this arrangement, the length of both the cable 55 connecting the laser noise reduction circuit 37 and the lens holder 60, and the cable 58 connecting the pre-amplifier circuit 36 and the lens holder 60 become shorter. Hence, it is possible to reduce the noise generated from the laser noise reduction circuit 37 and minimise the possibility of catching noise in the pre-amplifier circuit 36. Since both circuits 36 and 37 are located in a residual space between the housing 7 and the lens holder 60, a smaller and especially a shorter optical head can be provided.

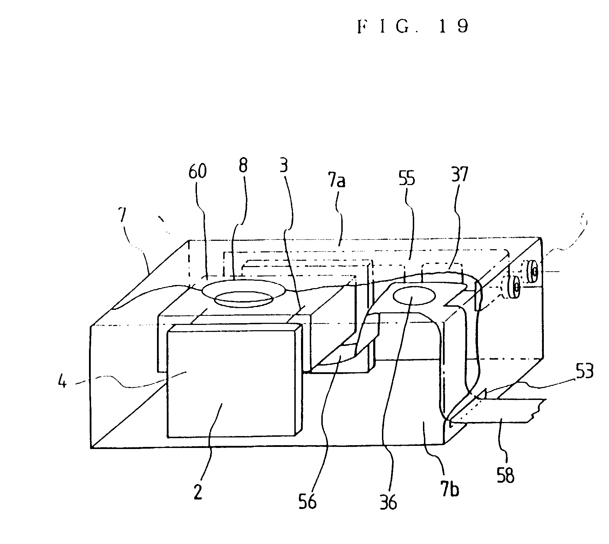

Referring to figure 19, another modified optical head 1 has the pre-amplifier circuit 36 disposed on the flat cable 58, and located just below the upper surface 7a of the housing 7 through which the laser beam is emitted. Therefore, tuning of the amplifier circuit 36 can be effected more easily from the upper surface, if necessary. In addition, the space for the other equipment, if necessary, can be kept below the circuit 36.

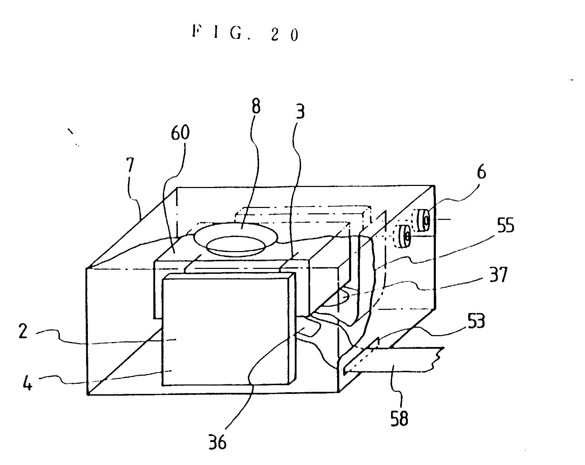

Referring to figure 20, another modified optical head 1 has the pre-amplifier circuit 36 disposed on the flat cable 58, and the laser noise reduction circuit 37 disposed on the flat cable 55, both of which contact the bottom surface of the lens holder 60. Therefore, the length of both cables between circuit 36, 37 and the lens holder 60 can be almost at its shortest. This arrangement is effective because it is possible to minimise noise leakage and suppress the noise into the pre-amplifier circuit 36 in spite of the very high frequency wave which is generated by the laser noise reduction circuit 37.

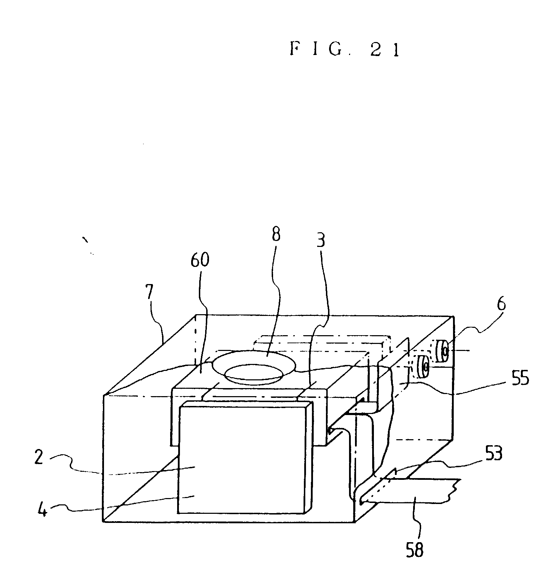

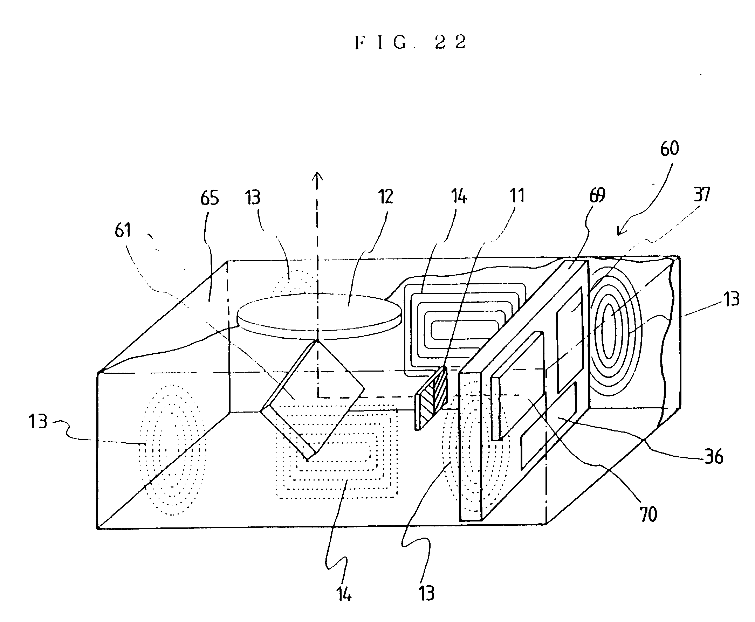

Referring to figures 21 and 22, another modified optical head 1 has the pre-amplifier circuit 36 and the laser noise reduction circuit 37 both arranged on the backside of a board 69. The laser emission unit 70 is mounted in front thereof, and a cable for connecting the board 69 outside the device extends from the lens holder 60 to outside of the housing 7. The board 69 (shown in figure 22), which has mounted thereon the laser emission unit 70 and other circuits, can be formed by either a plastic board or semiconductor wafer. If the board 69 is formed as a semiconductor wafer, the pre-amplifier circuit 36 and the laser noise reduction circuit 37 can be introduced on the board 69 by semiconductor processes. Since the circuits 36 and 37, and laser emission unit 70 are mounted on the same board 69, the distance between the circuits 36, 37 and the laser emission unit 70 can be minimised and both leakage of noise and catching of noise can be lowered. These circuits 36 and 37 may be mounted on the same surface on which the laser emission unit 70 is mounted. Alternatively, the pre-amplifier circuit 36 and the laser emission unit 70 may be on the same surface of the board 69 and the laser noise reduction circuit 37 may be on another surface.

### HOUSING OF AN OPTICAL HEAD OF THE THIRD EMBODIMENT

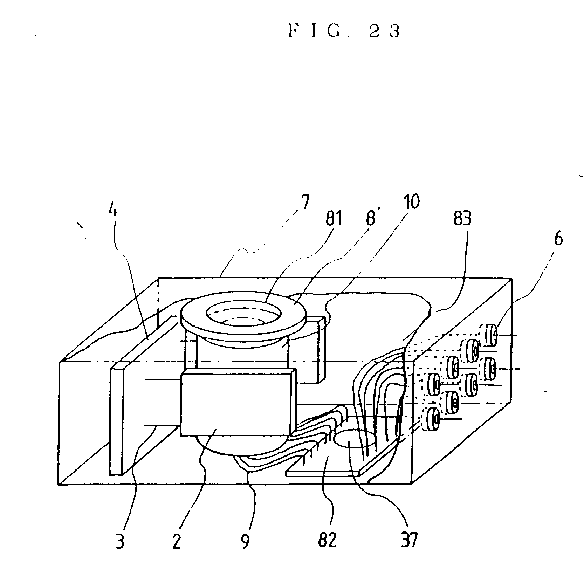

In figure 23, an optical head 1 of another embodiment of present invention are shown, which has a generally cylindrical-shaped lens holder the same as that of the first embodiment and a housing 7 of a shape and a material generally the same as those of the first embodiment.

Further, the optical head 1 of this embodiment has a transparent cover 81 on the laser emitting port 8 for covering this port 8. In addition the optical head 1 has a board 82 in the housing 7, the laser noise reduction circuit 37 arranged on the board 82, an internal wire connecting the lens holder 10 and the board 82, and an outgoing wire extending to outside of the housing 7 via a plurality of penetrating capacitors 6.

Because this optical head has the transparent cover 81 on the laser emitting port 8, the housing 7 is completely closed and no dust or other contaminative materials can come through into the housing 7. Since the optical head 1 of this embodiment has a superior dust proof characteristic, the optical head 1 is applicable in a dusty environment. Furthermore, the cover 81 can have an electrically conductive coating, and in addition to the shielding effect of the housing 7 itself, the leakage of noise from the optical head 1 can be shielded to the lowest level.

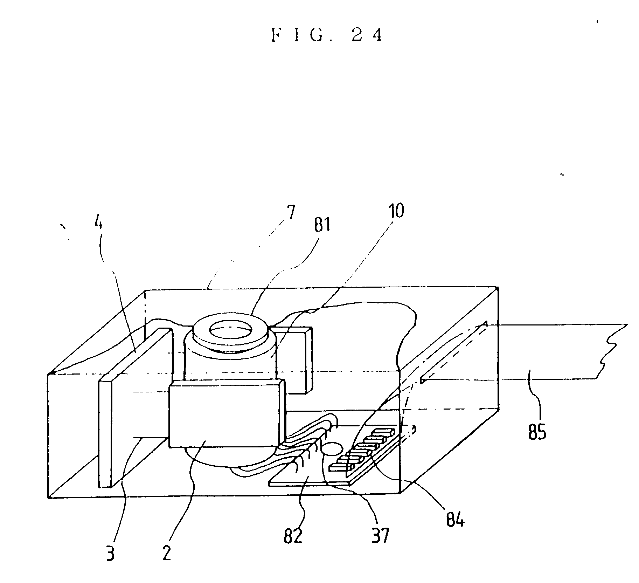

Referring to figure 24, a modified optical head of this embodiment has a plurality of low pass filters 84 disposed on the board 82, and a flat cable 85 which extends from inside of the housing 7 to the outside via the low pass filters.

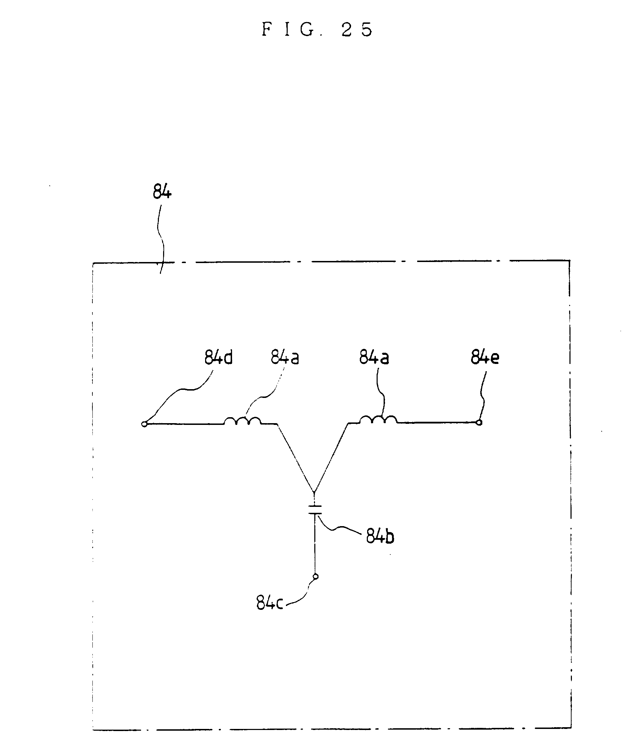

In figure 25, the components of one of the low pass filters 84 are shown. The low pass filter 84 is arranged by a LC network having two coils 84a connected in series, and a capacitor 84b: one terminal of which is connected between the coils 84a. The other terminal of the capacitor 84b is a grounding terminal 84c and this terminal 84c may be connected with a ground potential of the optical head 1. Though, this low pass filter 84, signals supplied at an input terminal 84d containing frequency components below a cut off frequency which is determined by the coils 84a and capacitor 84b can be passed. When the cut off frequency is sufficiently high then the range of signal to be handled in circuits such as the signal detection circuit 34, but is lower enough for the oscillating frequency of the high frequency wave generated and superimposed in the laser noise reduction circuit 37, then, the leakage of noise from the cables extending outside the housing can be prevented.

In this optical head 1, since low pass filters 84 can be pre-assembled on the board 82, the number of processes for assembling the optical head can be decreased. Further, since the low pass filter 84 can be assembled only using coils and a capacitor, the price of the low pass filters 84 is so low. Thus, assembly cost of the optical head having the low pass filters 84 can be decreased.

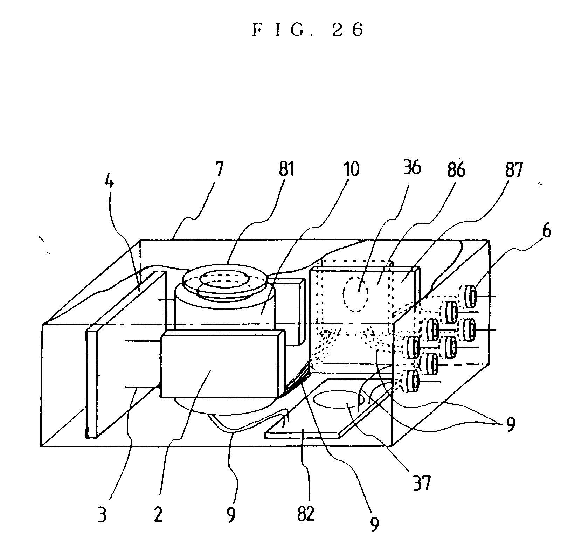

Referring to figure 26, another modified optical head 1 has a board 86 on a side wall of the housing 7, the pre-amplifier circuit 36 is arranged on the board 86, and an electrically conductive shielding panel 87 is disposed between the board 86 and the board 82 on which the laser noise reduction circuit 37 is arranged. Although in this optical head, the shielding panel 87 is disposed near the board 86 on which the pre-amplifier circuit 36 is arranged, the shielding panel 87 can be disposed near the board 82. Such arrangement may be desirable to protect the pre-amplifier circuit 36 from any leaked noise, if a high powered, high-frequency wave is generated in the laser noise reduction circuit 37.

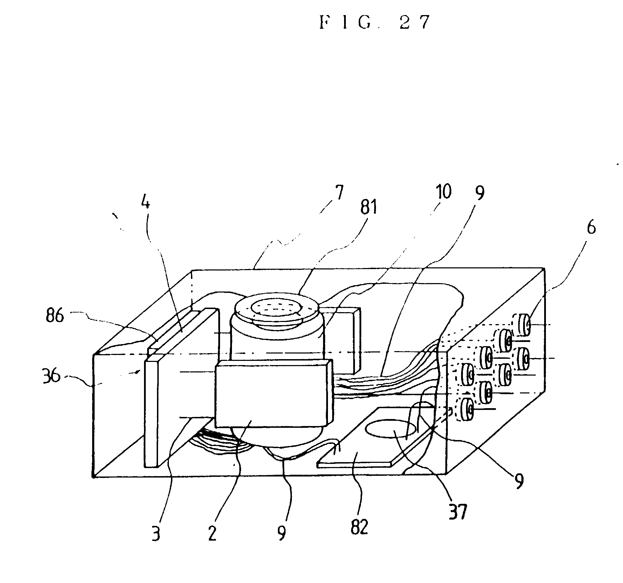

Referring to figure 27, another modified optical head 1 has the board 86 on which the pre-amplifier circuit 36 is arranged, and is located between the side wall of the housing 7 and the supporting plate 4 which supports the lens holder 10 by the spring 3. Since the supporting plate 4 and the lens holder 10 are arranged between the pre-amplifier circuit 36 and the laser noise reduction circuit 37, noise effect from the circuit 37 to the circuit 36 can be reduced, the same as applying an shielding panel. Further, because the board 86 containing the circuit 36, is inserted in a dead space between the supporting plate 4 and the side panel of the housing 7, space necessary for installing the circuit the circuit 36 can be saved and a smaller optical head can be provided. In addition, the distance between the pre-amplifier circuit 36 and the lens holder 10 is shorter, and the length of cable is decreased, so the pre-amplifier circuit 36 of this arrangement can provide relative tolerance of noise.

### LENS HOLDER

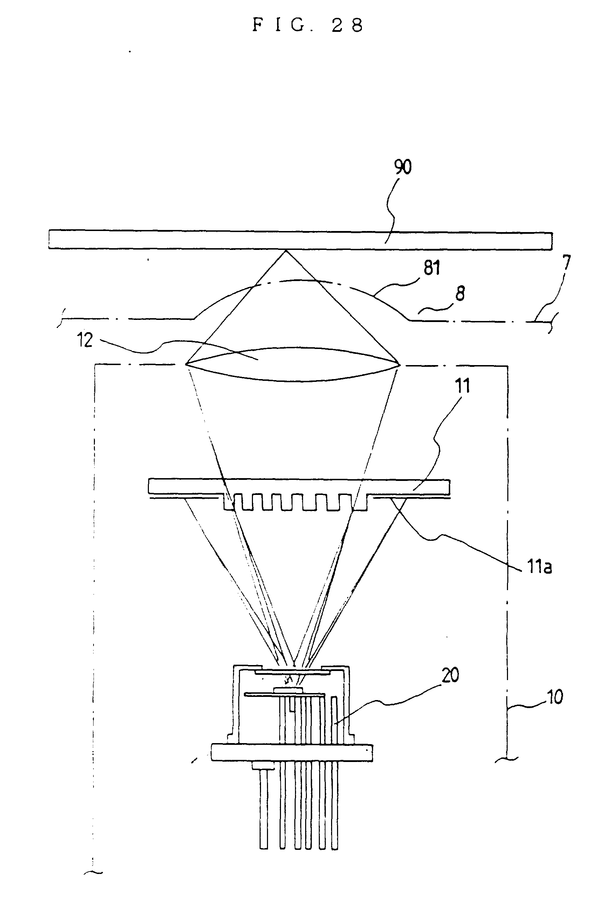

In figure 28, the lens holder 10 applied in this embodiment is illustrated schematically. A laser beam emitted from the laser emission unit 20 is focused on, for example an optical disk 90 by way of the diffraction grating 11, objective lens 12 and cover 81 installed on the emitting port 8. A part of the emitted laser beam from the unit 20 is reflected at a boundary area 11a of the diffraction grating 11, which does not have a diffraction grating shape, and is returned to the laser output power detection circuit in the laser emission unit 20. On the boundary area 11a of the diffraction grating 11, a reflection coating is applied, in order to sufficiently reflect the forwardly emitted laser beam to the power detection circuit so as to be able to confirm the power accurately. On the other hand, a reflected beam from the optical disk 90 is returned into the lens holder 10 via the cover 81 and the objective lens 12, and astigmatically converged on the laser emission unit 20 after diffraction on the diffraction grating 11. Then the reflected beam is detected by the signal detection circuit disposed in the laser emission unit 20. Since the laser unit 20 accomodated both the emitting part and receiving parts in itself, the light path of the laser beam can be commonly used and a smaller-sized optical head can be provided.

### LASER EMISSION UNIT

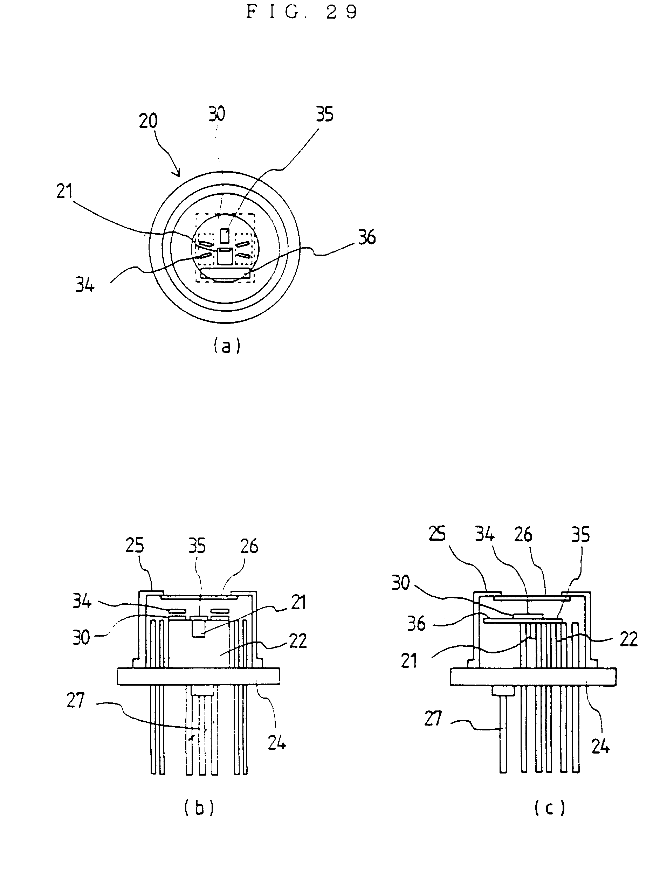

Referring to figure 29, the laser emission unit 20 applied to the above lens holder 10 has generally the same arrangement as that of the canned type, described before in the first embodiment. Further, in the laser emission unit 20, the wafer 30 is disposed on the top of the radiator 22 and has integrated thereon the laser output power detection circuit, the signal detection circuit and the pre-amplifier circuit. Since the laser diode 21 is also disposed on the top of the radiator 22, a hole for passing the laser beam is arranged in the wafer 30. A plurality of rod type electrodes 27 are so arranged that the top of the electrodes 27 are the same level as the top of the radiator 22, in order to easily connect the electrodes 27 and the wafer 30 by the bonding wire 28. The laser emission unit 20 has a plurality of circuits such as the laser output power detection circuit, the pre-amplifier circuit etc. and so the laser emission unit 20 can be termed a multi functioned laser unit.

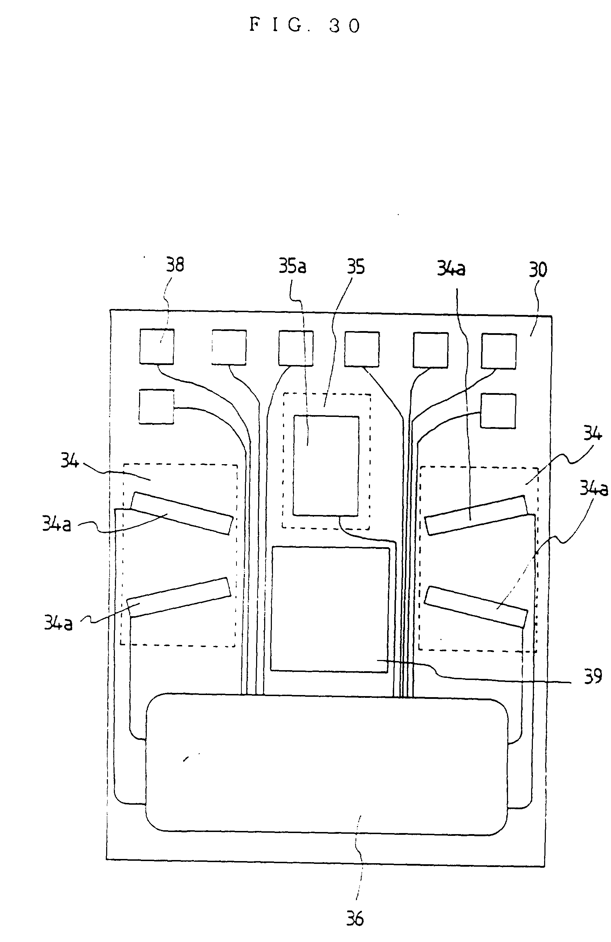

Referring to figure 30, the wafer 30 applied to the above laser unit 20, has the hole 39 of a generally rectangular shape for passing the laser beam from the laser diode 21 because the wafer 30 is disposed on the top of radiator as mentioned above. The signal detection circuits 34 are disposed on both sides of the hole 39, each containing two photo diodes 34a respectively. The laser output power detection circuit 35 is disposed on one of end of the wafer 30 and in line with the hole 39 together with a photo diode 35a. The pre-amplifier circuit 36 is disposed on another end of the wafer 30 and in line with the power detection circuit 35 and the hole 39. A plurality of electrodes 38 are disposed around the wafer 30.

In this wafer 30, signals generated from the laser output power detection circuit 35 and the signal detection circuit 34 are sent to the pre-amplifier circuit 36 disposed in the same wafer 30, and amplified after being changed from current signals to voltage ones. Since the distance between the circuits 34, 35 and the amplifier circuit 36 is so short, then the influence of noise is minimised. Further, on the identical wafer 30, in addition to the hole 39, the circuits 34, 35 and 36 can be made by semiconductor processes. Therefore, the laser diode and photo diodes are introduced at an accurate position with respect to each other. Thus, a high and stable quality laser emission unit can be provided. Also the same as the other embodiments mentioned before, manufacturing cost and time can be reduced.

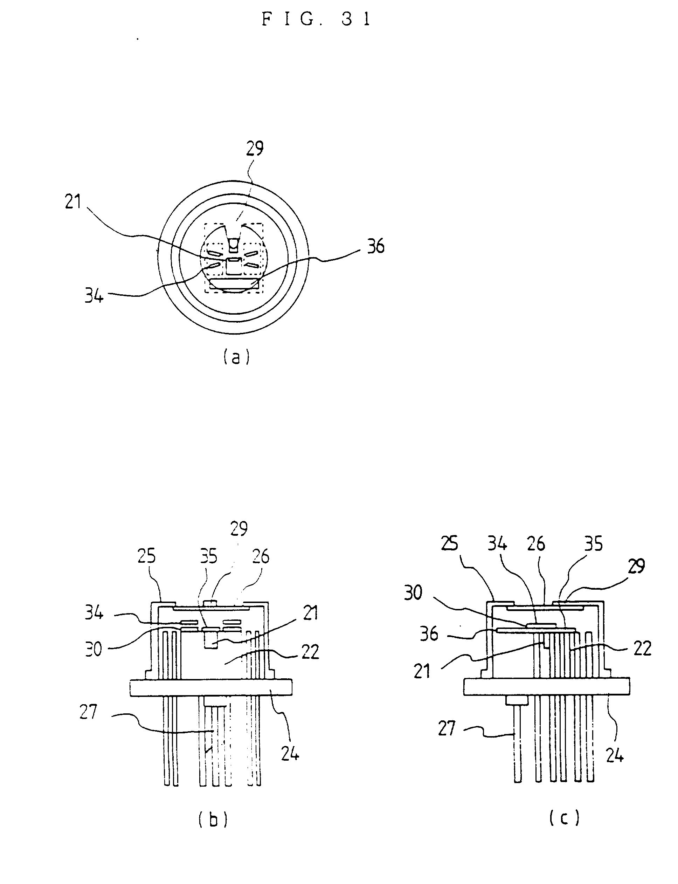

Referring to figure 31, a modified laser emission unit 20 has the wafer 30 containing the laser diode 21, the laser output power detection circuit 35 and the signal detection circuit 34 etc. In addition, this laser emission unit 20 has a reflected panel 29 disposed on the emitting window 26 of the cap 25, and extends from the periphery of the window to the centre of that. A part of the laser beam emitted forwardly from the laser diode is reflected at the reflecting panel 29 and received by the laser power detection circuit 35 on the wafer 30. It is to be noted that an emitting angle of the laser beam from the laser diode 21 has a part of this angle along the longer edge of laser diode 21 which is narrow, and another part of this angle along the shorter edge of laser diode 21 which is wide. Therefore, in the laser emission unit 20, the reflecting panel 29 extends in a direction perpendicular to the longer edge of the laser diode 21, namely in the direction of the shorter edge of the diode 21, in order to reflect a high intensity part of the forwardly emitted laser beam into the power detection circuit 35. Thus, the laser output power detection circuit 35 can detect the forwardly emitted laser beam effectively, and this arrangement can increase sensitivity of such detection.

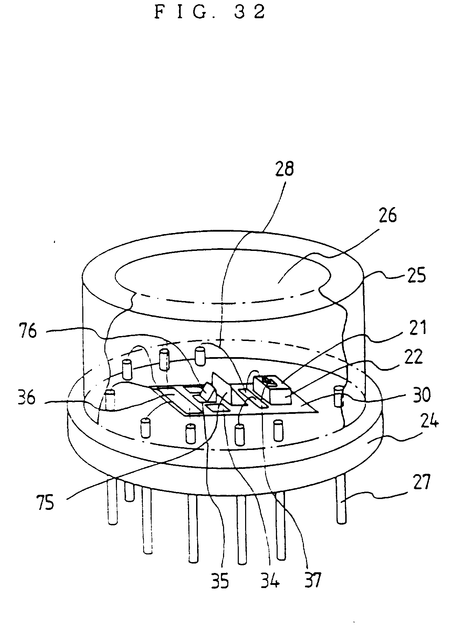

Referring to figure 32, another modified laser emission unit 20 is shown which is also of the canned type, but has the laser diode 21 disposed horizontally on the top of the radiator 22 which is located to one side of the centre of the disk like stem 24. On the other hand, there is disposed on the centre of the stem 24, a wafer 30 containing a main prism 75, a sub prism 76, the power detection circuit 35, and the signal detection circuit 34 where both are arranged either side of the prism 75. The pre-amplifier circuit 36 is arranged on one end of wafer 30 and the laser noise reduction circuit 37 and the radiator 22 are both arranged on the other end of the wafer 30. The circuits 34, 35, 36 and 37 are introduced on the wafer 30 by semiconductor manufacturing processes, and the main prism 75, the sub prism 76 and the radiator 22 are fixed on the wafer 30 by adhesive or other fixing material.

The direction of the major part of the laser beam emitted from the laser diode is disposed horizontally and changed by the main prism 75 perpendicularly up to the emitting window 26 through which the laser beam is output. The residual part of the laser beam goes through the main prism 75 and the direction of the residual beam is changed by the sub prism 76 into the photo diode of the laser power detection circuit 35. Hence, the laser output power detection circuit 35 installed in this laser emission unit 20 can detect a part of the forwardly emitted laser beam, and can confirm the power of output accurately. In this laser emission unit 20, since the light path of the laser beam is changed by the main prism 75 disposed on the centre of the unit 20, it is not necessary to install the laser diode 21 on the centre of the unit 20, and the arrangement in the unit 20 can be flexibly designed. Therefore, such positions and dimensions of the circuits become relatively free. Further, because the radiator 22 and prism are installed on the wafer 30, the dimensions of the wafer 30 can be larger and can be easily assembled on the stem 24.

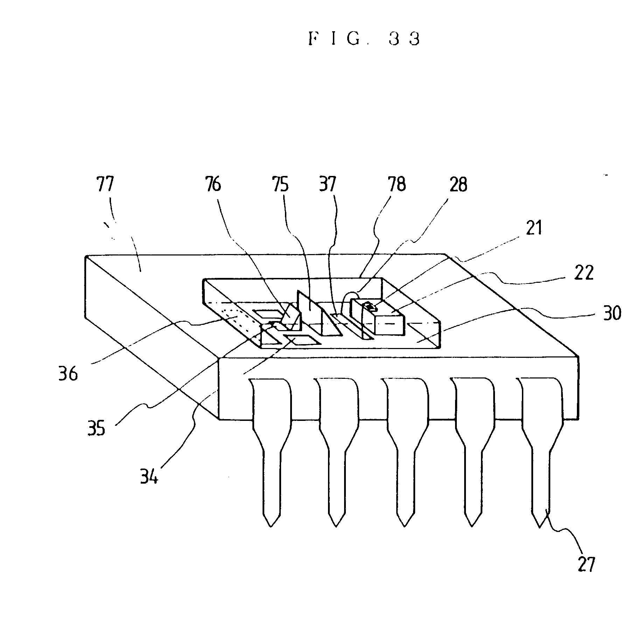

Referring to figure 33, a moulded type laser emission unit has the wafer 30 arranged as the same as the above wafer. A ceramic package 77 and transparent resin 78 mould the wafer 30 on the ceramic package 77. Since the unit moulding the wafer 30 on the package 77 is so thin and has a light weight, the optical head using this laser unit becomes smaller and can have lighter weight. Also, because the moulded ceramic package 77 enables a good fit on to a printed electrical board, the connection and cabling work between this laser unit and some outer circuits can be done easily, and also this laser emission unit can be assembled on the circuit board directly. In addition, since the moulding resin 78 is transparent but can reflect some part of the laser beam, the laser output power detection circuit 35 can detect the reflected beam from the resin 78.

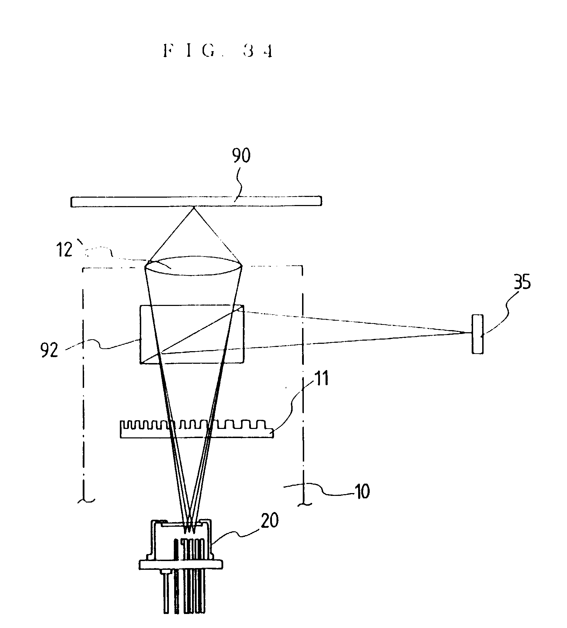

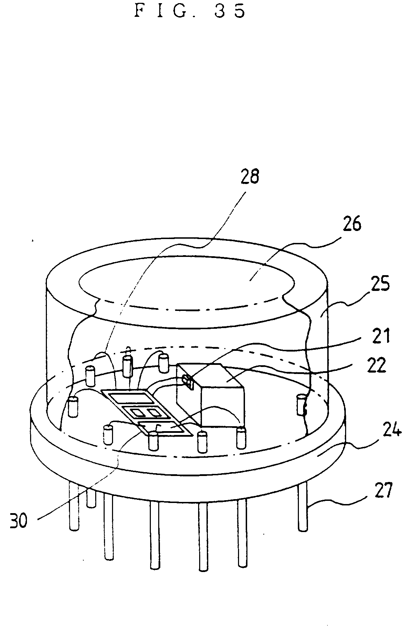

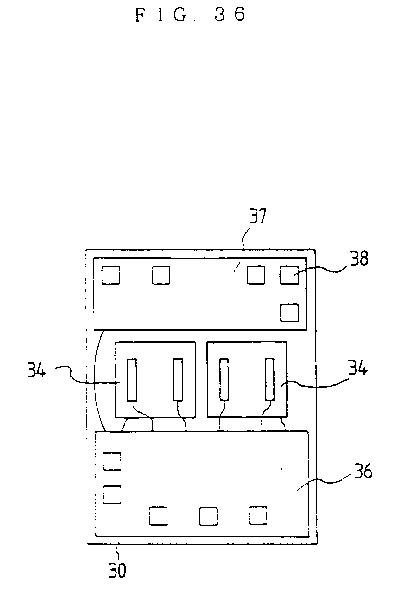

In figures 34, 35 and 36, another laser emission unit 20 is shown. In this laser emission unit 20, the laser output power detection circuit 35 is disposed outside of the unit 20 and the direction of part of the laser beam emitted from the laser emission unit 20 is changed outside, to the circuit 35 by a prism 92 disposed in, for example the lens holder. Referring to figure 35, this laser emission unit 20 has a wafer 30 arranged as shown in figure 36 containing the signal detection circuit 34, the pre-amplifier circuit 36, the laser noise reduction circuit 37, and laser diode 21. In this laser emission unit 20, the emitted laser beam is reflected by an optical disk etc., returned to the unit 20 by way of the same light path, and detected by the signal detection circuit 34 on the wafer 30. If this laser emission unit 20 is applied to the optical head, signal detection parts and a light path for signal detection of as in the prior optical head can be eliminated. Therefore, a smaller optical head can be provided. Since the laser output power detection circuit is arranged outside of the laser emission unit 20, the type and dimensions of the photo diode applied in the power detection circuit can be selected flexibly.

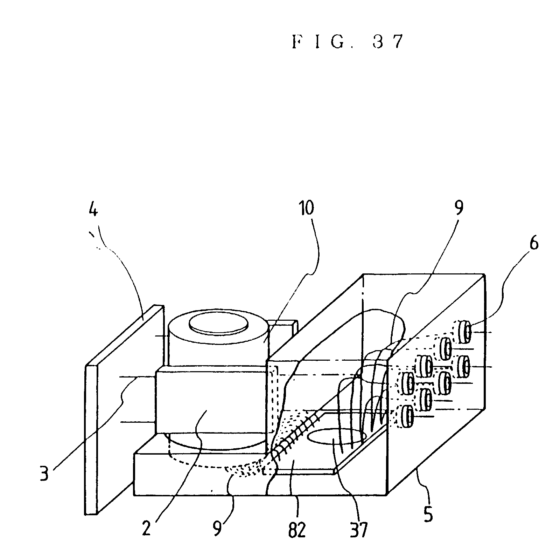

Referring to figure 37, another modified optical head 1 of this embodiment has a shielding unit 5 comprising a multi surface body surrounding the bottom part of the cylindrical lens holder 10 and a board 82 on which the laser noise reduction circuit 37 is mounted. The shielding unit 5 should be made of electrically conductive material in order to prevent leakage of the noise from the laser noise reduction circuit 37. In addition, the volume resistivity of the material used for the unit 5 should be less than 4x10⁻³ Ω·cm, and the unit 5 should be connected preferably with the ground side of the optical head or that of the laser emission unit 20, in order to get good shielding. Furthermore, in order to prevent resistive action to the magnetic field generated by the focusing coil, tracking coils and magnetic plates, the unit 5 should have a non-magnetic body made by for example, a metallic material, such as aluminium and copper, electrically conductive plastic, and formed plastic having a metallic coating or electrically conductive coating. If the body of the unit 5 is of magnesium then it has a lighter weight and superior shielding effect, and it is possible to reduce the load for position control for the lens holder 10. Although, in this optical head, the penetration capacitors are used to prevent the leakage from the wire outgoing from the unit 5, low pass filters can be applied instead of the capacitors.

In this optical head, since noise generated at the laser noise reduction circuit 37 can be shielded by the unit 5, it is not necessary to shield using the housing, and it is possible to eliminate the housing, if not required for the other reasons such as dust proofing. Therefore, a small optical head and smaller optical memory device can be provided because it is not necessary to keep a moving space for the optical head housing. In addition, if the housing can be eliminated, since the lens holder 10 may directly contact the air, the head radiation may be more effective and so a higher powered laser beam can be emitted.

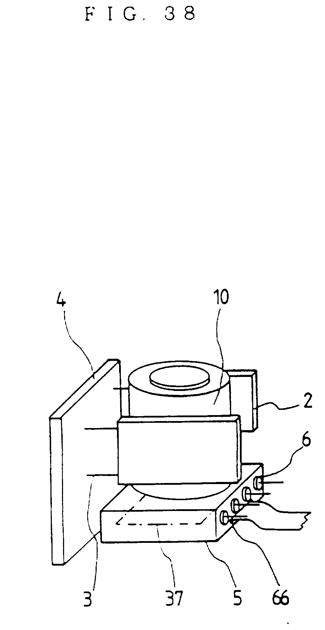

Referring to figure 38, another modified optical head 1 has a small shielding unit 5 containing the laser noise reduction circuit 37 therein, assembled below the cylindrical lens holder 10. Since the position of the lens holder 10 shall be controlled by the focusing coil or tracking coils, it is preferable that the weight and load to be controlled by the coils, can be decreased by applying the smaller shielding unit 5. Further, it may be possible to decrease the size of shielding unit 5, if the laser noise reduction circuit 37 is arranged on a flexible or flat cable, or on a semiconductor wafer.

Referring to 39, another modified optical head 1 has a lens holder 60 of a generally rectangular shape, and a shielding unit 5 containing the laser noise reduction circuit 37 which is also of a generally rectangular shape, and the same size as the lens holder 60. This shielding unit 5 is attached below the lens holder 60 by adhesive material or a screw, etc. In this optical head 1, since the rectangular lens holder 60 is usually thinner, it enables a thin type of optical head to be provided.

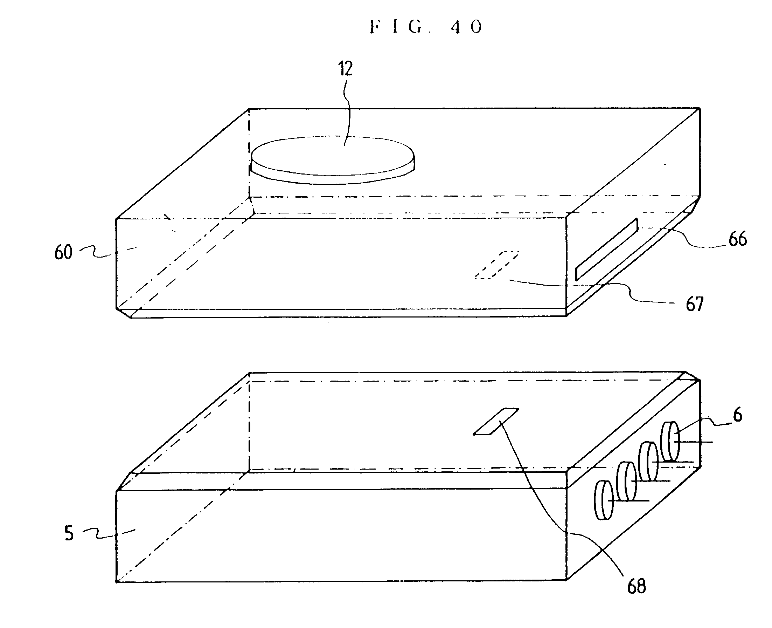

In figure 40, the outline of the lens holder 60 and shielding unit 5 is shown before assembly. This holder 60 has the objective lens 12 on an upper surface, a slit 67 on the bottom surface opposite to the upper surface for passing electrodes and a flexible cable, and a slit 66 on the side surface for passing the flexible cable. On the other hand, the unit 5 has a slit 68 of the same size as the slit 67 on the upper surface attached to holder 60 and opposite to the slit 67.

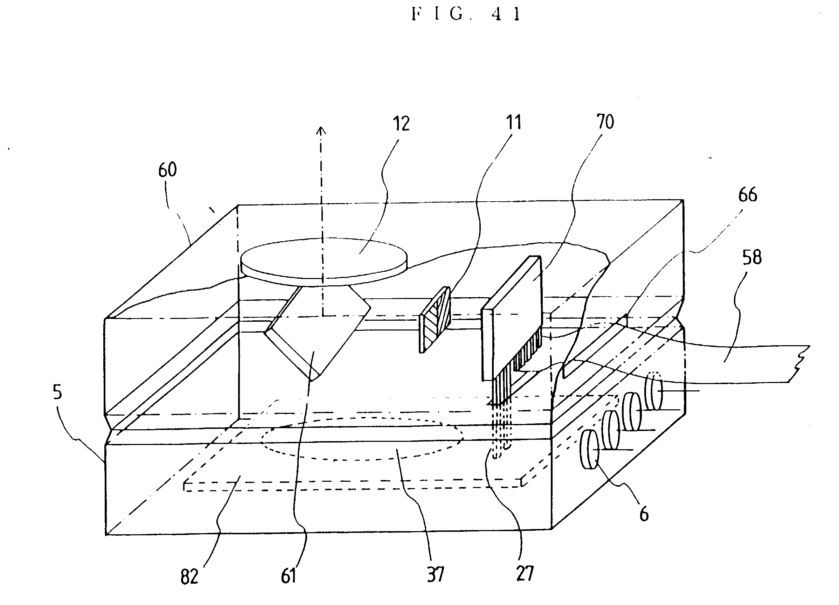

In figure 41, the arrangement of the components of the optical head 1 described above is shown. The lens holder 60 of this optical head 1 has an arrangement almost the same as that of the lens holder having a generally rectangular shape disclosed above. The lens holder 60 includes a laser emission unit 70 containing a wafer on which the laser diode, the laser output power detection circuit, the signal detection circuit and the pre-amplifier circuit are mounted, a diffraction grating 11, a mirror 61, and the objective lens 12. So, in the lens holder 60, the laser beam emitted from the laser emission unit 70 is focused on an optical disk by way of the mirror 61 and the objective lens 12. The reflected beam from the optical disk is returned inversely to the emission unit 70 by way of the objective lens 12, the mirror 61 and the diffraction grating 11. A part of the emitted beam is reflected by the diffraction grating 11 and returned into the emission unit 70 (as mentioned previously, a part of beam can be detected by another method without using the diffraction grating 11). Signals from the laser output power detection circuit and signal detection circuits, are transferred to the pre-amplifier circuit where the signals are amplified, and are delivered to outside from the lens holder via the flexible cable 58 which extends to the outside through the slit 66 arranged on a side of lens holder 60.

On the other hand, current for driving the laser diode in the laser emission unit 70, is input in the laser noise reduction circuit 37 disposed on the board 82 installed in the shielding unit 5 by way of penetrating capacitors 6 fixed on a side wall of unit 5. The driving current is supplied to the laser emission unit 70 for driving the laser diode via connecting electrodes 27, after a high frequency wave is superimposed on it at the laser noise reduction circuit 37. By way of the connecting electrodes 27 disposed in the slit 67 of the lens holder 60 and in slit 68 of the shielding unit 5, the board 82 is connected with the laser emission unit 70.

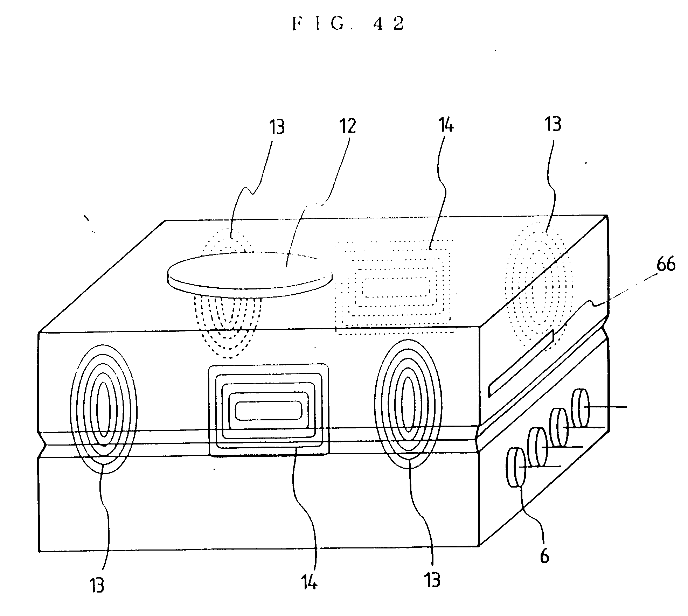

Referring to figure 42, the lens holder 60 has focusing coils and tracking coils on its side walls, in order to perform focusing and tracking by supplying some current to such coils as explained above. Since fine focusing and tracking is possible if the weight to be moved by these coils is light, this shielding unit 5 having thin and small dimensions is more preferable, and electrical consumption for focusing and tracking can be reduced. Also, in order to avoid blocking the fine position control by the magnetic field generated from the coils 13, 14 and magnetic plate 2 disposed both outside of lens holder 60, the shielding unit 5 should be of a non-magnetic body.

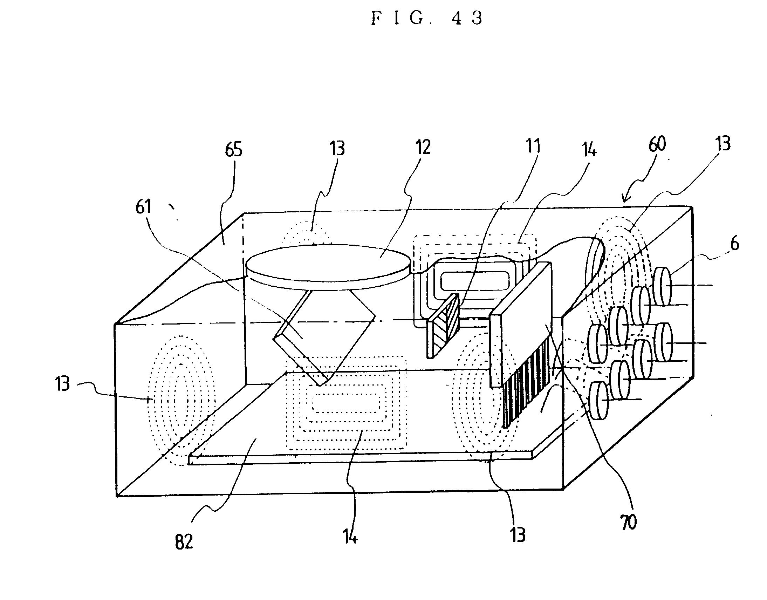

Referring to figure 43, another modified lens holder 60 having a generally rectangular shape, comprises a board 82 containing the laser noise reduction circuit 37 in addition to the laser emission unit 70, the diffraction grating 11, the mirror 61 and the objective mirror 12. In order to shield noise from the laser noise reduction circuit and to arrange the focusing coils and tracking coils on the side walls, the holder cover 65 is made of a material which is electrically conductive and non-magnetic for example, any one of the metallic materials such as aluminium and copper, an electrically conductive plastic, a formed plastic with treatment for being conductive by a metal coating or conductive painting etc., or magnesium by which the cover having a lighter weight and high shielding characteristics can be obtained. Also, a plurality of penetrating capacitors are installed on the side wall of the holder cover 65 in order to prevent the leakage of noise.

The optical head having a smaller size can be provided using the lens holder 60 integrating both of laser emitting and receipt parts. Further, since shielding of noise is performed by the lens holder 60 itself, the housing for the optical head can be eliminated, and the optical memory device having smaller dimensions can be provided using this optical head.

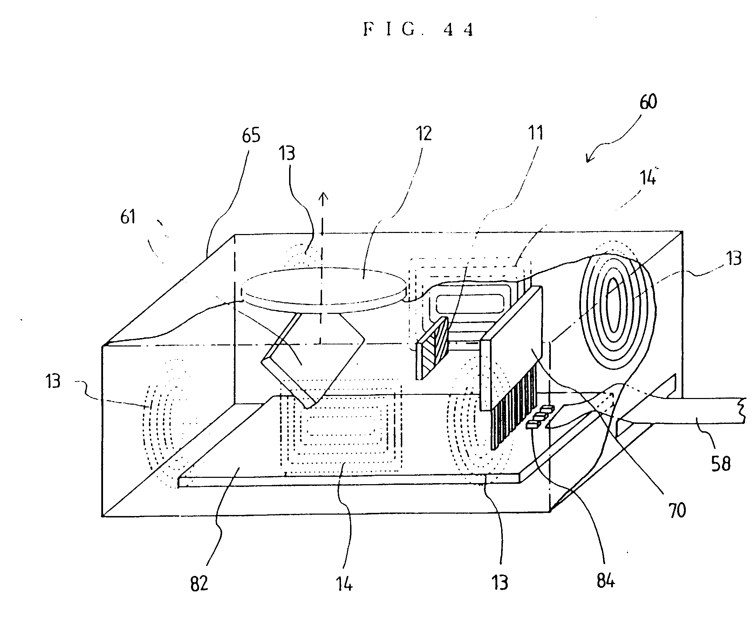

Referring to figure 44, another modified lens holder has a plurality of low pass filters 84 arranged on the board 82. Since the cable 58 connected with the low pass filters 84 carries signals and a current from the lens holder 60 to outside the equipment and vice versa, noise leakage from the lens holder 60 is prevented.

In addition, the low pass filters 84 have a simple arrangement, are light weight, of low cost, and are easy to assemble if preassembled on the board 82. Therefore, the optical head having a lighter weight and lower cost can be provided.

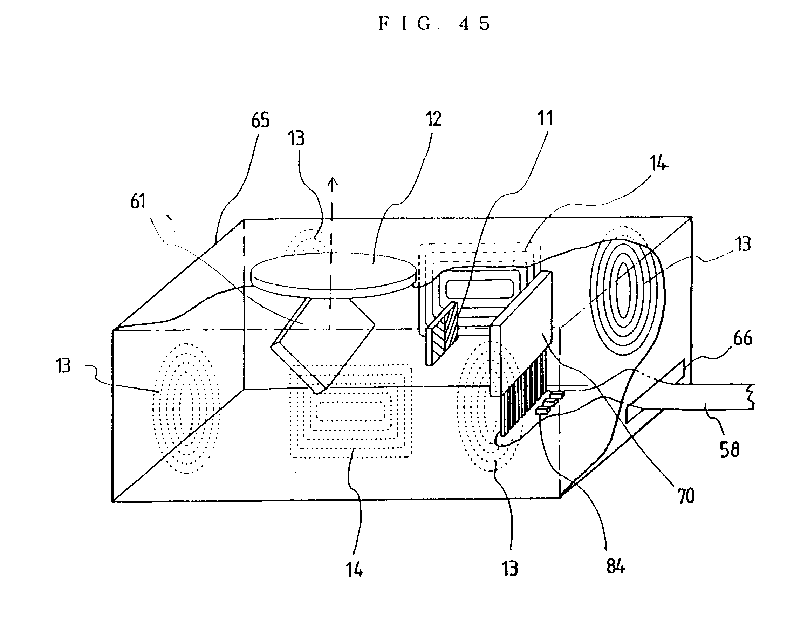

Referring to figure 45, another modified lens holder has a laser emission unit 70 containing the laser noise reduction circuit in addition to the laser output power detection circuit, signal detection circuit and pre-amplifier circuit, and a plurality of low pass filters disposed on the flexible cable 58 extending from electrodes 27 of the laser emission unit 70 to outside through the slit 66 on the holder 60.

In this lens holder 60, in addition to the circuits for laser emitting and receiving the other circuits up to the laser noise reduction circuit are integrated in the laser emission unit 70, and the lens holder 60 itself can serve as a shielding unit against noise. Therefore, this lens holder 60 containing the laser emission unit 70, the diffraction grating 11, the mirror 61 and the objective lens 12, can serve multiple functions such as laser emission, receipt, amplifier, laser noise reduction, shield for leakage of noise, and has a very small dimension and light weight. Moreover, this lens holder 60 is more preferable to provide an optical head having a minimised size especially thinner, and of a lighter weight.

As explained above, these embodiments of the present invention, enable the laser emission unit and optical head to have compact integrated laser emitting means or laser receiving means. In addition, noise shielding means and heat radiating means for a high power laser device are also considered. Therefore, applying the laser emission unit or optical head of the present invention, to an optical memory device in which an optical disk, magneto-optical disk etc. is used as a memory medium, means that a smaller size and lighter weight than that of the prior art, can be achieved.

The present invention has been described with reference to its preferred embodiments which are intended to be illustrative and not limited. Various changes may be made without departing from the scope of the present invention as defined in the following claims.

## Claims

1. An optical head (1) for reading from and writing into an optical medium, comprising:
a laser diode (21) for forwardly emitting a laser beam onto an optical medium from which the laser beam is reflected and returns as a returning beam;
signal detection means (34) for detecting the returning beam for determining signals;
converging means (12) for focusing the forwardly emitted laser beam onto the medium (90) and for passing through the returning beam reflected from the optical medium;
position control means (2) for finely controlling a focusing and a tracking of the forwardly emitted laser beam on the optical medium;
noise reduction means (37) for superposing a high frequency wave component onto an externally supplied driving current for driving said laser diode and for reducing a coherence of the forwardly emitted laser beam; and
characterised by further comprising:
a movable lens holder (10) including said laser diode, said signal detection means and said converging means, and having means (13, 14) arranged thereon for co-operating with said position control means magnetically and finely controlling its position so as to finely control a focusing and a tracking of the forwardly emitted laser beam on the optical medium; and
a housing (7), made of conductive material, accommodating said lens holder, said laser noise reduction means and connecting cables, and having a function of shielding noise from said noise reduction means.

2. The optical head of claim 1, wherein said housing has a plurality of ventilating holes (51).

3. The optical head of claim 2, wherein said housing is made of metallic material.

4. The optical head of claim 2, wherein said housing is made of non-magnetic and metallic material.

5. The optical head of claim 2, wherein said housing is made of conductive plastic.

6. The optical head of claim 2, wherein said housing is made of non-conductive material having conductive coating.

7. The optical head of claim 2, further comprising:
an emitting port (8), arranged on a wall of said housing, through which a laser beam is emitted; and
a transparent and conductive cover (81) for covering said emitting port.

8. The optical head of claim 2, wherein said housing is connected to a ground.

9. The optical head of claim 2, further comprising at least one capacitor (6) penetrating a wall of said housing and coupled between said laser noise reduction means and external circuits.

10. The optical head of claim 2, further comprising at least one low pass filter (84) disposed in said housing and coupled between said laser noise reduction means and external circuits.

11. The optical head of claim 2, wherein said laser noise reduction means is included in said lens holder.

12. The optical head of claim 2, further comprising pre-amplifier means (36), disposed in said housing, for amplifying signals generated from said lens holder.

13. The optical head of claim 2, further comprising pre-amplifier means, disposed in said housing, for amplifying signals generated from said lens holder, and
a shielding panel (87) disposed between said laser noise reduction means and said pre-amplifier means.

14. The optical head of claim 2, further comprising pre-amplifier means, disposed in said housing, for amplifying signals generated from said lens holder,
wherein said pre-amplifier means is disposed opposite to said laser noise reduction means between a side wall of said housing and said position control means.

15. The optical head of claim 2, further comprising pre-amplifier means, disposed in said housing, for amplifying signals generated from said lens holder,
wherein said pre-amplifier means is disposed between a side wall of said housing and said lens holder so as to minimise a connecting distance between said lens holder and said pre-amplifier means.

16. The optical head of claim 2, further comprising pre-amplifier means, disposed in said housing, for amplifying signals generated from said lens holder,
wherein said pre-amplifier means and said laser noise reduction means are disposed between a bottom part of said lens holder and a wall of said housing.

17. The optical head of claim 2, further comprising pre-amplifier means, disposed in said housing, for amplifying signals generated from said lens holder,
wherein said pre-amplifier means is disposed immediately below an upper wall of said housing.

18. The optical head of claim 2, further comprising pre-amplifier means, disposed in said housing, for amplifying signals generated from said lens holder,
wherein said pre-amplifier means and said laser noise reduction means are disposed to contact with a bottom part of said lens holder.

19. The optical head of claim 2, further comprising pre-amplifier means, disposed in said housing, for amplifying signals generated from said lens holder,
wherein said pre-amplifier means and said laser noise reduction means are disposed inside of said lens holder.

20. The optical head of claim 2, further comprising pre-amplifier means, disposed in said housing, for amplifying signals generated from said lens holder, and
a supporting means, disposed in said housing, for elastically supporting said lens holder,
wherein said pre-amplifier means is disposed between said supporting means and a wall of said housing.

## Patentansprüche

1. Optikkopf (1) zum Lesen von und Schreiben in ein optisches Medium, umfassend:
eine Laserdiode (21) zum vorwärts Emittieren eines Laserstrahls auf ein optisches Medium, von welchem der Laserstrahl reflektiert wird und als ein Rückstrahl zurückkehrt;
Signalerfassungsmittel (34) zum Erfassen des Rückstrahls für ein Bestimmen von Signalen;
Konvergenzmittel (12) zum Fokussieren des vorwärts emittierten Laserstrahls auf das Medium (90) und zum Durchführen des von dem optischen Medium reflektierten Rückstrahls;
Positionssteuermittel (2) zum feinen Steuern/Regeln einer Fokussierung und einer Spureinstellung des vorwärts emittierten Laserstrahls auf dem optischen Medium;
Rauschverringerungsmittel (37) zum Überlagern einer Hochfrequenzwellenkomponente auf einen extern gelieferten Ansteuerstrom zum Ansteuern der Laserdiode und zum Verringern einer Kohärenz des vorwärts emittierten Laserstrahls; und
**dadurch gekennzeichnet**, daß er ferner umfaßt:
einen bewegbaren Linsenhalter (10), der die Laserdiode, die Signalerfassungsmittel und die Konvergenzmittel aufweist, und Mittel (13, 14) daran angeordnet besitzt für ein magnetisches Zusammenwirken mit den Positionssteuermitteln und eine Feinsteuerung/regelung seiner Position, um eine Fokussierung und eine Spureinstellung des vorwärts emittierten Laserstrahls auf dem optischen Medium fein zu steuern/regeln; und
ein aus einem leitfähigen Material gebildetes Gehäuse (7), das den Linsenhalter, die Laserrauschverringerungsmittel sowie Verbindungsleitungen aufnimmt und eine Wirkung zum Abschirmen von Rauschen von den Rauschverringerungsmitteln besitzt.

2. Optikkopf nach Anspruch 1, wobei das Gehäuse eine Mehrzahl von Lüftungslöchern (51) aufweist.

3. Optikkopf nach Anspruch 2, wobei das Gehäuse aus metallischem Material gebildet ist.

4. Optikkopf nach Anspruch 2, wobei das Gehäuse aus nicht-magnetischem und metallischem Material gebildet ist.

5. Optikkopf nach Anspruch 2, wobei das Gehäuse aus leitfähigem Kunststoff gebildet ist.

6. Optikkopf nach Anspruch 2, wobei das Gehäuse aus nicht-leitfähigem Material mit leitfähiger Beschichtung gebildet ist.

7. Optikkopf nach Anspruch 2, ferner umfassend:
einen Emissionsdurchlaß (8), der an einer Wand des Gehäuses angeordnet ist, durch welchen ein Laserstrahl emittiert wird; und
eine transparente und leitfähige Abdeckung (81) zum Abdecken des Emissionsdurchlasses.

8. Optikkopf nach Anspruch 2, wobei das Gehäuse mit einer Masse verbunden ist.

9. Optikkopf nach Anspruch 2, ferner umfassend wenigstens einen Kondensator (6) der eine Wand des Gehäuses durchsetzt und zwischen den Laserrauschverringerungsmitteln und externen Schaltungen zwischengeschaltet ist.

10. Optikkopf nach Anspruch 2, ferner umfassend wenigstens ein Tiefpaßfilter (84), das in dem Gehäuse angeordnet ist und zwischen den Laserrauschverringerungsmitteln und externen Schaltungen zwischengeschaltet ist.

11. Optikkopf nach Anspruch 2, wobei die Laserrauschverringerungsmittel in dem Linsenhalter enthalten sind.

12. Optikkopf nach Anspruch 2, ferner umfassend Vorverstärkermittel (36), die in dem Gehäuse angeordnet sind, zum Verstärken von Signalen, die von dem Linsenhalter erzeugt werden.

13. Optikkopf nach Anspruch 2, ferner umfassend Vorverstärkermittel, die in dem Gehäuse angeordnet sind, zum Verstärken von Signalen, die von dem Linsenhalter erzeugt werden, und
eine Abschirmplatte (87), die zwischen den Laserrauschverringerungsmitteln und den Vorverstärkermitteln angeordnet ist.

14. Optikkopf nach Anspruch 2, ferner umfassend Vorverstärkermittel, die in dem Gehäuse angeordnet sind, zum Verstärken von Signalen, die von dem Linsenhalter erzeugt werden,
wobei die Vorverstärkermittel entgegengesetzt zu den Laserrauschverringerungsmitteln zwischen einer Seitenwand des Gehäuses und den Positionssteuermitteln angeordnet sind.

15. Optikkopf nach Anspruch 2, ferner umfassend Vorverstärkermittel, die in dem Gehäuse angeordnet sind, zum Verstärken von Signalen, die von dem Linsenhalter erzeugt werden,
wobei die Vorverstärkermittel zwischen einer Seitenwand des Gehäuses und dem Linsenhalter angeordnet sind, um eine Verbindungsdistanz zwischen dem Linsenhalter und den Vorverstärkermitteln zu minimieren.

16. Optikkopf nach Anspruch 2, ferner umfassend Vorverstärkermittel, die in dem Gehäuse angeordnet sind, zum Verstärken von Signalen, die von dem Linsenhalter erzeugt werden,
wobei die Vorverstärkermittel und die Laserrauschverringerungsmittel zwischen einem Bodenteil des Linsenhalters und einer Wand des Gehäuses angeordnet sind.

17. Optikkopf nach Anspruch 2, ferner umfassend Vorverstärkermittel, die in dem Gehäuse angeordnet sind, zum Verstärken von Signalen, die von dem Linsenhalter erzeugt werden,
wobei die Vorverstärkermittel unmittelbar unter einer oberen Wand des Gehäuses angeordnet sind.

18. Optikkopf nach Anspruch 2, ferner umfassend Vorverstärkermittel, die in dem Gehäuse angeordnet sind, zum Verstärken von Signalen, die von dem Linsenhalter erzeugt werden,
wobei die Vorverstärkermittel und die Laserrauschverringerungsmittel angeordnet sind, um mit einem Bodenteil des Linsenhalters in Kontakt zu treten.

19. Optikkopf nach Anspruch 2, ferner umfassend Vorverstärkermittel, die in dem Gehäuse angeordnet sind, zum Verstärken von Signalen, die von dem Linsenhalter erzeugt werden,
wobei die Vorverstärkermittel und die Laserrauschverringerungsmittel in dem Linsenhalter angeordnet sind.

20. Optikkopf nach Anspruch 2, ferner umfassend Vorverstärkermittel, die in dem Gehäuse angeordnet sind, zum Verstärken von Signalen, die von dem Linsenhalter erzeugt werden, und
ein Haltemittel, das in dem Gehäuse angeordnet ist, zum elastischen Halten des Linsenhalters,
wobei die Vorverstärkermittel zwischen den Haltemitteln und einer Wand des Gehäuses angeordnet sind.

## Revendications

1. Tête optique (1) pour lire à partir d'un support optique et pour écrire dans ce dernier, comprenant :
une diode laser (21) pour émettre vers l'avant un faisceau laser sur un support optique à partir duquel le faisceau laser est réfléchi et revient en tant que faisceau de retour ;
des moyens de détection de signal (34) pour détecter le faisceau de retour pour déterminer des signaux ;
des moyens de convergence (12) pour focaliser le faisceau laser émis vers l'avant sur le support (90) et pour laisser passer le faisceau de retour réfléchi à partir du support optique ;
des moyens de commande de position (2) pour commander de manière fine la focalisation et le suivi du faisceau laser émis vers l'avant sur le support optique ;
des moyens de réduction de bruit (37) pour superposer une composante d'onde à haute fréquence sur un courant de pilotage amené de manière externe pour piloter ladite diode laser et pour réduire la cohérence du faisceau laser émis vers l'avant ; et
caractérisée comme comprenant de plus :
un support de lentille mobile (10) incluant ladite diode laser, lesdits moyens de détection de signal et lesdits moyens de convergence, et ayant des moyens (13, 14) agencés sur ce dernier pour fonctionner de concert avec lesdits moyens de commande de position pour commander finement et de façon magnétique sa position de façon à commander finement la focalisation et le suivi du faisceau laser émis vers l'avant sur le support optique ; et
un logement (7), fait d'une matière conductrice, logeant ledit support de lentille, lesdits moyens de réduction de bruit de laser et des câbles de connexion, et ayant une fonction de protection contre le bruit provenant desdits moyens de réduction de bruit.

2. Tête optique selon la revendication 1, dans laquelle ledit logement possède une pluralité de trous de ventilation (51).

3. Tête optique selon la revendication 2, dans laquelle ledit logement est fait d'une matière métallique.

4. Tête optique selon la revendication 2, dans laquelle ledit logement est fait d'une matière métallique et non magnétique.

5. Tête optique selon la revendication 2, dans laquelle ledit logement est fait d'un plastique conducteur.

6. Tête optique selon la revendication 2, dans laquelle ledit logement est fait d'une matière non conductrice ayant un revêtement conducteur.

7. Tête optique selon la revendication 2, comprenant de plus :
un orifice d'émission (8), agencé sur une paroi dudit logement, à travers lequel un faisceau laser est émis ; et
un couvercle transparent et conducteur (81) pour recouvrir ledit orifice d'émission.

8. Tête optique selon la revendication 2, dans laquelle ledit logement est relié à la masse.

9. Tête optique selon la revendication 2, comprenant de plus au moins un condensateur (6) pénétrant dans une paroi dudit logement et relié entre lesdits moyens de réduction de bruit de laser et des circuits externes.

10. Tête optique selon la revendication 2, comprenant de plus au moins un filtre passe-bas (84) disposé dans ledit logement et relié entre lesdits moyens de réduction de bruit de laser et des circuits externes.

11. Tête optique selon la revendication 2, dans laquelle lesdits moyens de réduction de bruit de laser sont inclus dans ledit support de lentille.

12. Tête optique selon la revendication 2, comprenant de plus des moyens formant préamplificateur (36), disposés dans ledit logement, pour amplifier des signaux produits en provenance dudit support de lentille.

13. Tête optique selon la revendication 2, comprenant de plus des moyens formant préamplificateur, disposés dans ledit logement, pour amplifier des signaux produits en provenance dudit support de lentille, et
un panneau de protection (87) disposé entre lesdits moyens de réduction de bruit de laser et lesdits moyens formant préamplificateur.

14. Tête optique selon la revendication 2, comprenant de plus des moyens formant préamplificateur, disposés dans ledit logement, pour amplifier des signaux produits en provenance dudit support de lentille,
dans laquelle lesdits moyens formant préamplificateur sont disposés à l'opposé desdits moyens de réduction de bruit de laser entre une paroi latérale dudit logement et lesdits moyens de commande de position.

15. Tête optique selon la revendication 2, comprenant de plus des moyens formant préamplificateur, disposés dans ledit logement, pour amplifier des signaux produits en provenance dudit support de lentille,
dans laquelle lesdits moyens formant préamplificateur sont disposés entre une paroi latérale dudit logement et ledit support de lentille de façon à minimiser une distance de connexion entre ledit support de lentille et lesdits moyens formant préamplificateur.

16. Tête optique selon la revendication 2, comprenant de plus des moyens formant préamplificateur, disposés dans ledit logement, pour amplifier des signaux produits en provenance dudit support de lentille,
dans laquelle lesdits moyens formant préamplificateur et lesdits moyens de réduction de bruit de laser sont disposés entre un élément de fond dudit support de lentille et une paroi dudit logement.

17. Tête optique selon la revendication 2, comprenant de plus des moyens formant préamplificateur, disposés dans ledit logement, pour amplifier des signaux produits en provenance dudit support de lentille,
dans laquelle lesdits moyens formant préamplificateur sont disposés immédiatement au-dessous d'une paroi supérieure dudit logement.

18. Tête optique selon la revendication 2, comprenant de plus des moyens formant préamplificateur, disposés dans ledit logement, pour amplifier des signaux produits en provenance dudit support de lentille,
dans laquelle lesdits moyens formant préamplificateur et lesdits moyens de réduction de bruit de laser sont disposés pour venir en contact avec un élément de fond dudit support de lentille.

19. Tête optique selon la revendication 2, comprenant de plus des moyens formant préamplificateur, disposés dans ledit logement, pour amplifier des signaux produits en provenance dudit support de lentille,
dans laquelle lesdits moyens formant préamplificateur et lesdits moyens de réduction de bruit de laser sont disposés à l'intérieur dudit support de lentille.

20. Tête optique selon la revendication 2, comprenant de plus des moyens formant préamplificateur, disposés dans ledit logement, pour amplifier des signaux produits en provenance dudit support de lentille, et
des moyens de support, disposés dans ledit logement, pour supporter de façon élastique ledit support de lentille,
dans laquelle lesdits moyens formant préamplificateur sont disposés entre lesdits moyens de support et une paroi dudit logement.
